# EUROPEAN PATENT APPLICATION

(11) **EP 4 651 185 A1**
(43) Date of publication of application: **19.11.2025**
(21) Application number: 24741495.6
(22) Date of filing: 09.01.2024
(51) Int. Cl.: H01L 21/60, B32B 7/025, B32B 15/00, C08G 73/06, C08L 101/00, H01L 23/29, H01L 23/31, H01L 25/065, H01L 25/07, H01L 25/18

(54) **LAMINATE, SEMICONDUCTOR ELEMENT, AND MEMS ELEMENT**

(30) Priority: 11.01.2023 JP 2023002175
(71) Applicant: Toray Industries, Inc., Tokyo 103-8666 (JP)
(72) Inventor: ARAKI, Hitoshi, Otsu-shi, Shiga 520-8558 (JP); FUJIWARA, Takenori, Otsu-shi, Shiga 520-8558 (JP); SHOJI, Yu, Otsu-shi, Shiga 520-8558 (JP)
(74) Representative: Hoefer & Partner Patentanwälte mbB
(86) International application number: PCT/JP2024/000108
(87) International publication number: WO 2024/150722

(57) **Abstract**

Si0₂, which is a material in conventional insulation layers, has presented the problem of weak bonding strength. Additional problems were presented in terms of poor electroconductivity of electrodes and reduced reliability of a resulting laminate due to voids caused by microscopic foreign matter being caught in the bonding interface. Provided is a laminate in which a first substrate, which is provided with (A-1) a metal electrode and (B-1) a resin layer that are exposed on the same surface of the substrate body, and a second substrate, which is provided with (A-2) a metal electrode and (B-2) a resin layer that are exposed on the same surface of the substrate body or with the (A-2) metal electrode and (C) an inorganic insulation layer that are exposed on the same surface of the substrate body, are affixed together so that at least a portion of the (A-1) metal electrode and the (A-2) metal electrode and at least a portion of the (B-1) resin layer and the (B-2) resin layer, or at least a portion of the (A-1) metal electrode and the (A-2) metal electrode and at least a portion of the (B-1) resin layer and the (C) inorganic insulation layer, are each directly bonded, wherein at least one of the (B-1) resin layer and the (B-2) resin layer contains a resin having one or more selected from the group consisting of carbonyl groups, hydroxyl groups, alkylene oxide groups, groups having siloxane bonds, and nitrogen-containing heterocycles.

## Description

### TECHNICAL FIELD

The present invention relates to a laminate, a semiconductor element, and an MEMS element. More specifically, the present invention relates to a technique of mounting an element by direct bonding using a metal electrode and an insulating film.

### BACKGROUND ART

Conventionally, when a chip of a semiconductor or micro electro mechanical systems (MEMS) is electrically connected to the outside, a protruding electrode (bump) of gold, copper, or the like is formed and connected to a connection substrate or the like via solder. Techniques such as underfill have been established to maintain insulation between electrodes. In recent years, as the number of electrodes connected to the outside is greatly increased and the electrode density is increased due to high integration of chips, a hybrid bonding technique in which an electrode and an insulating film are formed in the same plane without forming a bump and are connected to the outside by direct bonding has attracted attention (Patent Document 1). This enables high-density mounting with an electrode pitch of 10 µm or less. Hybrid bonding includes W2W (wafer-to-wafer) by which wafers are bonded and C2W (chip-to-wafer) by which a chip and a wafer are bonded.

### PRIOR ART DOCUMENTS

### PATENT DOCUMENT

Patent Document 1: JP 2006-517344 A

### NON-PATENT DOCUMENT

Non-Patent Document 1: Y. Kagawa et al. "Novel stacked CMOS image sensor with advanced Cu2Cu hybrid bonding", 2016 IEEE International Electron Devices Meeting (IEDM), DOI: 10.1109/IEDM.2016.7838375

### SUMMARY OF THE INVENTION

### PROBLEMS TO BE SOLVED BY THE INVENTION

In hybrid bonding, SiO₂, which is a conventional insulating layer, has a problem of low bonding strength. In addition, in the case of bonding a semiconductor element by C2W, there is a problem that voids are easily generated due to minute foreign matters generated when a chip is diced being sandwiched in a bonding interface, and conduction failure of an electrode or deteriorated reliability of a resulting laminate.

### SOLUTIONS TO THE PROBLEMS

To solve the above-described problems, the present invention has the following configurations.
[1] A laminate in which
   a first substrate including an exposed (A-1) metal electrode and an exposed (B-1) resin layer provided on the same face of a substrate body, and
   a second substrate including an exposed (A-2) metal electrode and an exposed (B-2) resin layer, or an exposed (A-2) metal electrode and an exposed (C) inorganic insulating layer, provided on the same face of a substrate body

   are laminated together such that
      the (A-2) metal electrode and at least a part of the (A-1) metal electrode, and the (B-2) resin layer and at least a part of the (B-1) resin layer, or
      the (A-2) metal electrode and at least a part of the (A-1) metal electrode, and the (C) inorganic insulating layer and at least a part of the (B-1) resin layer
   are directly bonded, respectively,
   wherein at least one of the (B-1) resin layer and the (B-2) resin layer contains a resin having one or more selected from the group consisting of a carbonyl group, a hydroxy group, alkylene oxide groups, groups having a siloxane linkage, and nitrogen-containing heterocyclic rings.
[2] The laminate according to [1], wherein the second substrate includes the exposed (A-2) metal electrode and the exposed (B-2) resin layer provided on the same face of a substrate body.
[3] The laminate according to [1] or [2], wherein the alkylene oxide group is a group represented by formula (1): 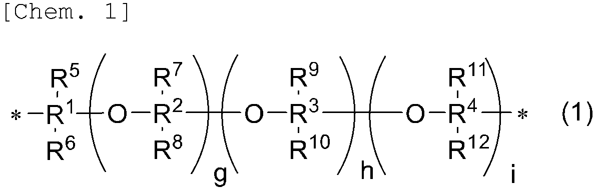 in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; parenthesized structures are different from each other; g, h, and i each independently represent an integer of 0 to 35, and g + h + i > 0; sign * represents a bonding site.
[4] The laminate according to any one of [1] to [3], wherein the group having a siloxane linkage is a group represented by formula (2): 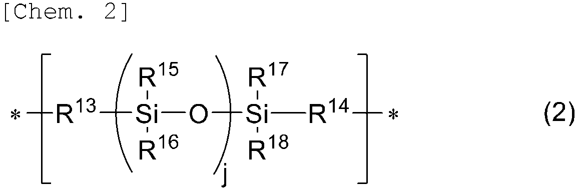 in the formula (2), j is a natural number of 1 to 50; R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms; R¹⁵ to R¹⁸ each independently represent an alkyl group having 1 to 30 carbon atoms, a phenyl group, or a phenoxy group; sign * represents a bonding site.
[5] The laminate according to [3] or [4], wherein
   at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2).
[6] The laminate according to any one of [1] to [5], wherein the resin contained in at least one of the (B-1) resin layer and the (B-2) resin layer contains two or more types of structures represented by formula (9): 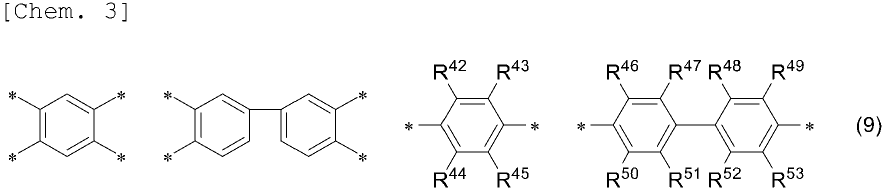 wherein sign * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.
[7] The laminate according to any one of [1] to [6], wherein a coefficient of thermal expansion of at least one of the (B-1) resin layer and the (B-2) resin layer in a temperature range of 50°C to 150°C is 10 ppm/K or more and 40 ppm/K or less.
[8] The laminate according to any one of [1] to [7], wherein at least one of the (B-1) resin layer and the (B-2) resin layer further contains an antioxidant.
[9] The laminate according to any one of [1] to [8], wherein at least one of the (B-1) resin layer and the (B-2) resin layer forms a crosslinked structure.
[10] The laminate according to any one of [1] to [9], wherein at least one of the (B-1) resin layer and the (B-2) resin layer has an elastic modulus of 1.5 GPa or more and 7 GPa or less.
[11] The laminate according to any one of [1] to [10], wherein a plurality of singulated pieces of the first substrate is directly bonded onto the same face of the second substrate.
[12] The laminate according to any one of [1] to [11], wherein a bonding strength between the first substrate and the second substrate as measured in a die shear test is 10 MPa or more.
[13] The laminate according to any one of [1] to [12], wherein at least one of the substrate bodies of the first substrate and the second substrate contains one or more selected from the group consisting of silicon, niobium lithate, tantalum lithate, gallium nitride, silicon carbide, gallium arsenide, and indium phosphide.
[14] A semiconductor element including the laminate according to any one of [1] to [13].
[15] An MEMS element including the laminate according to any one of [1] to [14].

### EFFECTS OF THE INVENTION

The laminate of the present invention has high bonding strength and few voids in the boding surface, and thus has high reliability.

### BRIEF DESCRIPTION OF THE DRAWINGS

Fig. 1 is a sectional view of a laminate produced by W2W.
Fig. 2 is a sectional view of a laminate produced by C2W.
Fig. 3 is a process diagram of the production of a laminate by W2W.
Fig. 4 is a process diagram of the production of a laminate by C2W.

### EMBODIMENTS OF THE INVENTION

The laminate of the present invention is obtained by laminating
a first substrate including an exposed (A-1) metal electrode and an exposed (B-1) resin layer provided on the same face of a substrate body, and
a second substrate including an exposed (A-2) metal electrode and an exposed (B-2) resin layer, or an exposed (A-2) metal electrode and an exposed (C) inorganic insulating layer, provided on the same face of a substrate body,

such that
   the (A-2) metal electrode and at least a part of the (A-1) metal electrode, and the (B-2) resin layer and at least a part of the (B-1) resin layer, or
   the (A-2) metal electrode and at least a part of the (A-1) metal electrode and the (C) inorganic insulating layer and at least a part of the (B-1) resin layer
are directly bonded, respectively.

Here, the direct bonding means that two surfaces are bonded without using any material that assists bonding, such as an adhesive. For example, while an electrically conductive bonding aid such as solder is generally used when bonding electrodes to each other, a bonding method using no bonding aid is called direct bonding. Hereinafter, the materials and the producing process of the laminate will be described.

The laminate of the present invention has an (A-1) metal electrode and an (A-2) metal electrode (these two electrodes may hereinafter be collectively referred to as "(A) metal electrode"). In addition, the (A-1) metal electrode and the (A-2) metal electrode are preferably made of the same metal, but may be made of different metals. As the (A) metal electrode, metals such as copper, gold, silver, aluminum, platinum, titanium, chromium, molybdenum, zinc, nickel, and magnesium can be used. An alloy or a laminate of these metals may also be used. In addition, an electrically conductive metal oxide such as ITO or ZnO may be used. Among them, a copper electrode and a copper electrode including a barrier metal are preferable from the viewpoint of electrical conductivity, thermal conductivity, and economic efficiency (cost). Examples of the barrier metal include nickel, chromium, and molybdenum. In the case where the (A) metal electrode is a copper electrode, when the thickness of an oxide film at the bonding interface of the electrode is 0 nm or more and 200 nm or less, the resistance of the electrode decreases, which is preferable.

The laminate of the present invention has a (B-1) resin layer and a (B-2) resin layer (these two layers may hereinafter be collectively referred to as "(B) resin layer"). Alternatively, the laminate of the present invention has a (B-1) resin layer and a (C) inorganic insulating layer. The laminate of the present invention preferably has a (B-1) resin layer and a (B-2) resin layer. That is, the second substrate includes an exposed (A-2) metal electrode and an exposed (B-2) resin layer, or an exposed (A-2) metal electrode and an exposed (C) inorganic insulating layer, and it is preferable that the second substrate includes the exposed (A-2) metal electrode and the exposed (B-2) resin layer provided on the same face of the substrate body. The (B-1) resin layer and the (B-2) resin layer are preferably made of the same resin, but may be made of different resins.

At least one of the (B-1) resin layer and the (B-2) resin layer contains a resin having one or more among a carbonyl group, a hydroxy group, alkylene oxide groups, groups having a siloxane linkage, and nitrogen-containing heterocyclic rings. Due to the presence of these chemical structures, chemical interaction at the interface is strengthened, and high adhesive strength is exhibited.

That is, when the second substrate includes the exposed (A-2) metal electrode and the exposed (B-2) resin layer, the laminate includes the (B-1) resin layer and the (B-2) resin layer. In this case, at least one of the (B-1) resin layer and the (B-2) resin layer contains a resin having one or more among a carbonyl group, a hydroxy group, alkylene oxide groups, groups having a siloxane linkage, and nitrogen-containing heterocyclic rings. When the second substrate includes the exposed (A-2) metal electrode and the exposed (C) inorganic insulating layer, the laminate does not include a (B-2) resin layer. In this case, the (B-1) resin layer contains a resin having one or more selected from the group consisting of a carbonyl group, a hydroxy group, alkylene oxide groups, groups having a siloxane linkage, and nitrogen-containing heterocyclic rings.

The expression "at least one of the (B-1) resin layer and the (B-2) resin layer" described above shall represent at least one of the (B-1) resin layer and the (B-2) resin layer when both the (B-1) resin layer and the (B-2) resin layer are included in the laminate, and represent the (B-1) resin layer when the laminate does not contain the (B-2) resin layer.

Examples of the functional group containing a carbonyl group include amides, esters, ketones, aldehydes, urethanes, ureas, and imides, and examples of the resin having a carbonyl group include acrylic resins, polyimides, polyimide precursors, polybenzoxazole precursors, polyamides, polyureas, polyurethanes, polyesters, maleimides, and maleic acid resins. Here, the polyamides refer to polyamides other than the polyimide precursors and the polybenzoxazole precursors unless otherwise specified.

Examples of the hydroxy group include an alcoholic hydroxy group, a phenolic hydroxy group, and a silanolic hydroxy group, and these hydroxy groups can be introduced as functional groups of various resins. Representative examples include phenol resins, polyvinyl alcohols, and polysiloxanes. Preferred examples of R¹ to R⁴ include a pethylene group, a propylene group, and a butylene group, and preferred examples of R⁵ to R¹² include a hydrogen atom, a methyl group, and an ethyl group.

Examples of the alkylene oxide group include an ethylene oxide group, a propylene oxide group, a butylene oxide group, an epoxy group, and an oxetanyl group. In particular, it is preferable that the resin contained in at least one of the (B-1) resin layer and the (B-2) resin layer has a group represented by the following formula (1) in which those groups are complexly contained from the viewpoint of adhesive strength and the reliability of resin.

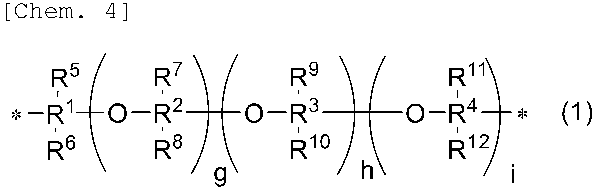

In the formula (1), R¹ to R⁴ each independently represent an alkylene group having 1 to 6 carbon atoms. R⁵ to R¹² each independently represent a hydrogen atom, a fluorine atom, or an alkyl group having 1 to 6 carbon atoms. It is noted that parenthesized structures are different from each other. g, h, and i each independently represent an integer of 0 to 35, and g + h + i > 0. sign * represents a bonding site.

Examples of the resin having an alkylene oxide group include polyalkylene oxide, epoxy resins, and condensation resins such as polyimide and polyamide each having an alkylene oxide group.

Examples of the group having a siloxane linkage include groups having a structure of (Si(R)₂-O) (D2 unit), (Si(R)-O)_{3/2} (T3 unit), and (Si-O)₂ (Q4 unit) (R is an organic group having carbon bonded to silicon). Among them, the D2 unit is preferable from the viewpoint of adhesive strength at the time of direct bonding, and the group represented by the formula (2) is more preferable.

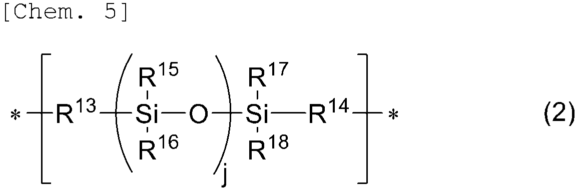

In the formula (2), j is a natural number of 1 to 50. R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms. R¹⁵ to R¹⁸ each independently represent an alkyl group having 1 to 30 carbon atoms, a phenyl group, or a phenoxy group. sign * represents a bonding site.

Preferred examples of R¹³ and R¹⁴ include a propylene group, a butylene group, a vinylene group, and a phenylene group, and preferred examples of R¹⁵ to R¹⁸ include a methyl group and a phenyl group.

As the nitrogen-containing heterocyclic ring, a group having a heterocyclic structure containing nitrogen can be arbitrarily selected, and examples thereof include a cyclic imide group, an oxazole group, an imidazole group, an oxazoline group, and an oxazine group. Examples of the resins containing them include polyimides, polybenzoxazoles, polybenzimidazoles, and polybenzoxazines.

Examples of the resin containing a group having a siloxane linkage specifically include polysiloxane, dimethylsilicone, polyimide siloxane, and siloxane-modified benzocyclobutene. Among them, a resin having a group represented by the formula (2) is preferable. In particular, a polyimide siloxane having a group represented by the formula (2) and a siloxane-modified benzocyclobutene are more preferable from the viewpoint of adhesiveness and reliability.

Next, details of the various resins described above will be described below.

Examples of the acrylic resin include a resin obtained by radically polymerizing a (meth)acrylic acid or a (meth)acrylic acid ester is preferable. Among them, a carboxyl group-containing acrylic resin is preferable from the viewpoint of adhesiveness at the time of direct bonding, and it is preferable that an ethylenically unsaturated double bond group is introduced into at least a part of the carboxyl group-containing acrylic resin from the viewpoint of chemical resistance. The term "(meth)acrylic acid" as used herein refers to methacrylic acid or acrylic acid. Hereinafter, the same applies to similar descriptions.

Examples of the method for synthesizing the acrylic resin include radical polymerization of a (meth)acrylic compound. Examples of the (meth)acrylic compound include a carboxyl group-containing and/or acid anhydride group-containing (meth)acrylic compound and other (meth)acrylic acid esters. As the catalyst for the radical polymerization, for example, azo compounds such as azobisisobutyronitrile or organic peroxides such as benzoyl peroxide are commonly used.

As the (meth)acrylic acid ester, methyl (meth)acrylate, ethyl (meth)acrylate, propyl (meth)acrylate, cyclopropyl (meth)acrylate, cyclopentyl (meth)acrylate, cyclohexyl (meth)acrylate, cyclohexenyl (meth)acrylate, 4-methoxycyclohexyl (meth)acrylate, 2-cyclopropyloxycarbonylethyl (meth)acrylate, 2-cyclopentyloxycarbonylethyl (meth)acrylate, 2-cyclohexyloxycarbonylethyl (meth)acrylate, 2-cyclohexenyloxycarbonylethyl (meth)acrylate, and the like are used.

Further, the acrylic resin may be a copolymer of a (meth)acrylic compound and another unsaturated double bond-containing monomer. Examples of other unsaturated double bond-containing monomers include styrene, p-methylstyrene, o-methylstyrene, m-methylstyrene, α-methylstyrene, p-hydroxystyrene, maleic anhydride, norbornene, norbornene dicarboxylic acid, norbornene dicarboxylic anhydride, cyclohexene, butyl vinyl ether, butyl allyl ether, 2-hydroxyethyl vinyl ether, 2-hydroxyethyl allyl ether, cyclohexane vinyl ether, cyclohexane allyl ether, and 4-hydroxybutyl vinyl ether.

As the acrylic resin having an ethylenically unsaturated bond, those obtained by radically polymerizing a carboxyl group-containing and/or an acid anhydride group-containing (meth)acrylic compound, (meth)acrylic acid ester and/or another unsaturated double bond-containing monomer, and then performing an addition reaction with an epoxy compound having an ethylenically unsaturated double bond group are preferable. Examples of the catalyst used in the addition reaction include amino catalysts such as dimethylaniline, 2,4,6-tris(dimethylaminomethyl)phenol, and dimethylbenzylamine, phosphorus catalysts such as triphenylphosphine, ammonium catalysts such as tetrabutylammonium acetate, and chromium catalysts such as chromium acetylacetonate and chromium chloride.

Examples of the epoxy compound having an ethylenically unsaturated double bond group include glycidyl (meth)acrylate, α-ethylglycidyl (meth)acrylate, 3,4-epoxybutyl (meth)acrylate, butyl vinyl ether, butyl allyl ether, 2-hydroxyethyl vinyl ether, 2-hydroxyethyl allyl ether, cyclohexane vinyl ether, cyclohexane allyl ether, o-vinylbenzyl glycidyl ether, and m-vinylbenzyl glycidyl ether.

Examples of the polysiloxane include a hydrolysis condensate using at least one organosilane compound. Examples of the organosilane compound include: tetrafunctional silanes such as tetramethoxysilane, tetraethoxysilane, tetraacetoxysilane, and tetraphenoxysilane; trifunctional silanes such as methyltrimethoxysilane, methyltriethoxysilane, ethyltrimethoxysilane, ethyltriethoxysilane, n-propyltrimethoxysilane, n-propyltriethoxysilane, n-hexyltrimethoxysilane, n-hexyltriethoxysilane, decyltrimethoxysilane, vinyltrimethoxysilane, vinyltriethoxysilane, 3-methacryloxypropyltrimethoxysilane, 3-acryloyloxypropyltrimethoxysilane, phenyltrimethoxysilane, phenyltriethoxysilane, p-hydroxyphenyltrimethoxysilane, 1-(p-hydroxyphenyl)ethyltrimethoxysilane, 2-(p-hydroxyphenyl)ethyltrimethoxysilane, trifluoromethyltrimethoxysilane, 3,3,3-trifluoropropyltrimethoxysilane, 3-aminopropyltrimethoxysilane, 3-aminopropyltriethoxysilane, 3-glycidoxypropyltrimethoxysilane, 2-(3,4-epoxycyclohexyl)ethyltrimethoxysilane, [(3-ethyl-3-oxetanyl)methoxy]propyltrimethoxysilane, [(3-ethyl-3-oxetanyl)methoxy]propyltriethoxysilane, 3-mercaptopropyltrimethoxysilane, 3-trimethoxysilylpropylsuccinic acid, 1-naphthyltrimethoxysilane, '1-naphthyltri-n-propoxysilane, 2-naphthyltrimethoxysilane, 1-anthracenyltrimethoxysilane, 9-anthracenyltrimethoxysilane, 9-fluorenyltrimethoxysilane, and 2-fluorenyltrimethoxysilane; difunctional silanes such as dimethyldimethoxysilane, dimethyldiethoxysilane, di-n-butyldimethoxysilane, diphenyldimethoxysilane, (3-glycidoxypropyl)methyldimethoxysilane, and di(1-naphthyl)dimethoxysilane; monofunctional silanes such as trimethylmethoxysilane, tri-n-butylethoxysilane, (3-glycidoxypropyl)dimethylmethoxysilane, and (3-glycidoxypropyl)dimethylethoxysilane. Two or more types of these organosilanes may be used.

Hydrolysis reaction conditions of the organosilane compounds may be appropriately set, and for example, it is preferable that an acid catalyst and water are added to the organosilane compounds over 1 to 180 minutes in a solvent, and then the mixture is reacted at room temperature to 110°C for 1 to 180 minutes. When the hydrolysis reaction is performed in such conditions, a rapid reaction can be suppressed. A reaction temperature is more preferably 30 to 105°C.

Further, the hydrolysis reaction is preferably performed in the presence of the acid catalyst. As the acid catalyst, an acidic aqueous solution containing formic acid, acetic acid or phosphoric acid is preferred. The content of these acid catalyst is preferably 0.1 to 5 parts by mass based on 100 parts by mass of all the organosilane compounds used in the hydrolysis reaction. When the content of the acid catalyst is in this range, the hydrolysis reaction can be easily controlled to proceed to a necessary and sufficient extent. A certain amount of silanol groups may be left.

With respect to conditions of the condensation reaction, for example, it is preferred that after a silanol compound is obtained by the hydrolysis reaction of the organosilane compounds, a reaction liquid is heated for 1 to 100 hours at a temperature of 50°C to a boiling point of the solvent or lower as it is. Further, to increase the polymerization degree of the polysiloxane, the reaction liquid may be reheated or a basic catalyst may be added. Further, after the hydrolysis reaction, an appropriate amount of the produced alcohol and the like may be distilled off and removed by heating and/or reduced pressure, and then an arbitrary solvent may be added as necessary.

The siloxane-modified benzocyclobutene resin is produced, for example, by reacting a brominated arylcyclobutene compound with a compound containing an unsaturated alkyl group in the presence of a palladium catalyst. Examples thereof specifically include benzocyclobutene having a siloxane structure represented by the formula (2), and divinylsiloxane bisbenzocyclobutene is preferable. Further, examples of the commercially available benzocyclobutene compound include "CYCLOTENE" 3022-63 or 4026-46 (these are trade names, manufactured by The Dow Chemical Company).

Examples of the polyimide siloxane include polyimides obtained using at least one of an acid dianhydride having a siloxane structure and a diamine having a siloxane structure as a monomer. Specific examples of the monomer are enumerated as examples in the following description on a polyimide precursor.

Examples of the epoxy resin include a resin obtained by curing a known epoxy compound. Examples of the epoxy compound include bisphenol A diglycidyl ether, cresol novolak resin type polyfunctional glycidyl ether, ethylene glycol diglycidyl ether, and hydrogenated bisphenol A diglycidyl ether. Examples thereof specifically include EPOLIGHT (registered trademark) 40E, EPOLIGHT 100E, EPOLIGHT 200E, EPOLIGHT 400E, EPOLIGHT 70P, EPOLIGHT 200P, EPOLIGHT 400P, EPOLIGHT 1500NP, EPOLIGHT 80MF, EPOLIGHT 4000, EPOLIGHT 3002 (trade names, manufactured by Kyoeisha Chemical Co., Ltd.), DENACOL EX-212L, DENACOL EX-214L, DENACOL EX-216L, DENACOL EX-321L, DENACOL EX-850L (trade names, manufactured by Nagase ChemteX Corporation), EPIKOTE 828, EPIKOTE 1002, EPIKOTE 1750, EPIKOTE 1007, YX8100-BH30, E1256, E4250, E4275 (trade names, manufactured by Japan Epoxy Resins Co., Ltd.), EPICLON EXA-9583, EPICLON N666, EPICLON N695, HP4032, HP7200 (trade names, manufactured by DIC Corporation), TECHMORE VG3101L (trade name, manufactured by Printec Corporation), TEPIC S, TEPIC G, TEPIC P (trade names, manufactured by Nissan Chemical Corporation), Epotohto YH-434L (trade name, manufactured by Tohto Kasei Co., Ltd.), GAN, GOT, EPPN502H, NC3000, or NC6000 (trade names, manufactured by Nippon Kayaku Co., Ltd.), YDPN-638, YDCN-700-7, YDCN-700-10, YDCN-704, and YDCN-704A (trade names, manufactured by NIPPON STEEL Chemical & Material Co., Ltd.).

Examples of the phenolic resin include a novolac resin and a resol resin, and the phenolic resin is obtained by polycondensation of various phenols alone or a mixture thereof with aldehydes such as formalin.

Examples of the phenols constituting a novolac resin and a resol phenol resin include phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylenebisphenol, methylenebis p-cresol, resorcin, catechol, 2-methylresorcin, 4-methylresorcin, o-chlorophenol, m-chlorophenol, p-chlorophenol, 2,3-dichlorophenol, m-methoxyphenol, p-methoxyphenol, p-butoxyphenol, o-ethylphenol, m-ethylphenol, p-ethylphenol, 2,3-diethylphenol, 2,5-diethylphenol, p-isopropylphenol, p-phenylphenol, α-naphthol, and β-naphthol, and these can be used alone or as a mixture thereof.

Further, examples of the aldehydes used for polycondensation with the novolac resin or the resol resin include, in addition to formalin, paraformaldehyde, acetaldehyde, benzaldehyde, hydroxybenzaldehyde, and chloroacetaldehyde, and these can be used alone or as a mixture thereof.

Further, the phenol resin may have a structure in which some of hydrogen atoms added to an aromatic ring are substituted with one or more among an alkyl group having 1 to 20 carbon atoms, a fluoroalkyl group, a hydroxy group, an alkoxyl group, an alkoxymethyl group, a methylol group, a carboxyl group, an ester group, a nitro group, a cyano group, a fluorine atom, and a chlorine atom.

In particular, from a viewpoint of dielectric reduction, a novolak resin or a resol resin having a rigid naphthalene structure or a biphenyl structure is more preferable, and specifically, p-phenylphenol, α-naphthol, or β-naphthol is preferably used as phenol. Further, examples of commercially available phenol resins include PN-80, PN-100, GPH-65, GPH-103 (trade names, manufactured by Nippon Kayaku Co., Ltd.), XLC-3L (which is a trade name, manufactured by Mitsui Chemicals, Inc.), and MEHC-7851SS (trade name, manufactured by Meiwa Plastic Industries, Ltd.), and GPH-65, GPH-103, and MEHC-7851SS each having a rigid structure are particularly preferable.

The maleic acid resin is produced by, for example, copolymerizing maleic anhydride or maleic acid ester with a compound containing an unsaturated alkyl group under a radical polymerization catalyst. Specific examples thereof include a styrene maleic anhydride copolymer and maleic anhydride-modified polyethylene. Further, examples of commercially available maleic acid resins include "XIRAN" 1000, "XIRAN" 1440, "XIRAN" 2000, "XIRAN" 2500, "XIRAN" 3000, "XIRAN" 3500, "XIRAN" 4000, "XIRAN" 6000, and "XIRAN" 9000 (trade names, manufactured by TOMOE Engineering Co., Ltd.).

Examples of the polyimide precursors include those obtained by reacting a tetracarboxylic acid and a derivative thereof with a diamine and a derivative thereof. As the polyimide precursors, for example, polyamic acid, polyamide acid esters, polyamic acid amides, or polyisoimides can be considered.

Examples of the tetracarboxylic acid and derivatives thereof include: 1,2,4,5-benzenetetracarboxylic acid (pyromellitic acid), 3,3',4,4'-biphenyltetracarboxylic acid, 2,3,3',4'-biphenyltetracarboxylic acid, 2,2',3,3'-biphenyltetracarboxylic acid, 1,2,5,6-naphthalenetetracarboxylic acid, 1,4,5,8-naphthalenetetracarboxylic acid, 2,3,6,7-naphthalenetetracarboxylic acid, 3,3', 4,4'-benzophenonetetracarboxylic acid, 2,2', 3,3'-benzophenonetetracarboxylic acid, bis(3,4-dicarboxyphenyl)methane, bis(2,3-dicarboxyphenyl)methane, 1,1-bis(3,4-dicarboxyphenyl)ethane, 1,1-bis(2,3-dicarboxyphenyl)ethane, 2,2-bis(3,4-dicarboxyphenyl)propane, 2,2-bis(2,3-dicarboxyphenyl)propane, 2,2'-bis[4-(3,4-dicarboxyphenoxy)phenyl]propane, 2,2-bis(3,4-dicarboxyphenyl)hexafluoropropane, 2,2-bis(2,3-dicarboxyphenyl)hexafluoropropane, bis(3,4-dicarboxyphenyl) sulfone, bis(3,4-dicarboxyphenyl) ether, 2,3,5,6-pyridinetetracarboxylic acid or 3,4,9,10-perylenetetracarboxylic acid, N,N'-bis[5,5'-hexafluoropropane-2,2-diyl-bis(2-hydroxyphenyl)]bis(3,4-dicarboxybenzoic acid amide), bicyclo[2.2.2]oct-7-ene-2,3,5,6-tetracarboxylic acid, 1,2,4,5-cyclohexanetetracarboxylic acid, 1,2,3,4-cyclopentanetetracarboxylic acid, 1,2,3,4-cyclobutanetetracarboxylic acid or 2,3,4,5-tetrahydrofurantetracarboxylic acid, butane-1,2,3,4-tetracarboxylic acid, or their tetracarboxylic dianhydrides, tetracarboxylic acid dichlorides or tetracarboxylic acid active diesters. These compounds may be used singly or two or more of them may be used in combination.

The use of a tracarboxylic acid or an acid dianhydride each having a siloxane structure is preferable because direct bonding can be performed at a low temperature of about room temperature to 100°C. Examples of the acid dianhydride having a siloxane structure include X-22-168AS, X-22-168 A, X-22-168B, and X-22-168-P5-B.

Examples of the diamine and derivatives thereof include: m-phenylenediamine, p-phenylenediamine, 3,5-diaminobenzoic acid, 4,4'-diaminobiphenyl, bis(4-aminophenoxy)biphenyl, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,2'-bis(trifluoromethyl)-4,4'-diaminobiphenyl, dimercaptophenylenediamine, 1,5-naphthalenediamine, 2,6-naphthalenediamine, 9,10-anthracenediamine, 4,4'-diaminobenzanilide, 3,4'-diaminodiphenyl ether, 4,4'-diamino diphenyl ether, 3-carboxy-4,4'-diaminodiphenyl ether, 3-sulfonic acid-4,4'-diaminodiphenyl ether, bis[4-(4-aminophenoxy)phenyl] ether, 1,4-bis(4-aminophenoxy)benzene, 1,3-bis(3-aminophenoxy)benzene, 1,3-bis(4-aminophenoxy)benzene, 3,4'-diaminodiphenylmethane, 4,4'-diaminodiphenylmethane, 2,2-bis(4-aminophenyl)hexafluoropropane, 3,3'-diaminodiphenyl sulfone, 3,4'-diaminodiphenyl sulfone, 4,4'-diaminodiphenyl sulfone, bis(4-aminophenoxyphenyl) sulfone, bis(3-aminophenoxyphenyl) sulfone, 2,7-diaminofluorene, 9,9-bis(4-aminophenyl)fluorene, 2-(4-aminophenyl)-5-aminobenzoxazole, 2-(3-aminophenyl)-5-aminobenzoxazole, 2-(4-aminophenyl)-6-aminobenzoxazole, 2-(3-aminophenyl)-6-aminobenzoxazole, 1,4-bis(5-amino-2-benzoxazolyl)benzene, 1,4-bis(6-amino-2-benzoxazolyl)benzene, 1,3-bis(5-amino-2-benzoxazolyl)benzene, 1,3-bis(6-amino-2-benzoxazolyl)benzene, 2,6-bis(4-aminophenyl)benzobisoxazole, 2,6-bis(3-aminophenyl)benzobisoxazole, bis[(3-aminophenyl)-5-benzoxazolyl], bis[(4-aminophenyl)-5-benzoxazolyl], bis[(3-aminophenyl)-6-benzoxazolyl], bis[(4-aminophenyl)-6-benzoxazolyl], 3,4'-diaminodiphenyl sulfide, 4,4'-diaminodiphenyl sulfide, 4-aminophenyl 4-aminobenzoate, 1,3-bis(4-anilino)tetramethyldisiloxane, ethylenediamine, 1,3-diaminopropane, 2-methyl-1,3-propanediamine, 1,4-diaminobutane, 1,5-diaminopentane, 2-methyl-1,5-diaminopentane, 1,6-diaminohexane, 1,2-cyclohexanediamine, 1,4-cyclohexanediamine, bis(4-aminocyclohexyl)methane, 1,7-diaminoheptane, 1,8-diaminooctane, 1,9-diaminononane, 1,10-diaminodecane, 1,11-diaminoundecane, 1,12-diaminododecane, and dimer diamine.

In addition, owing to having a phenolic hydroxy group, the adhesive force at the time of direct bonding can be improved, and when the metal electrode is copper or silver, corrosion can be reduced. Therefore, a bisaminophenol compound is preferable. Examples of the bisaminophenol compound include: bis(3-amino-4-hydroxyphenyl) ether, bis(3-amino-4-hydroxyphenyl) methylene, bis[N-(3-aminobenzoyl)-3-amino-4-hydroxyphenyl] sulfone, bis[N-(4-aminobenzoyl)-3 amino-4-hydroxyphenyl] sulfone, bis(3-amino-4-hydroxyphenyl) sulfone, bis(3-amino-4-hydroxyphenyl)propane, 2,2'-bis[N-(3-aminobenzoyl)-3-amino-4-hydroxyphenyl]propane, 2,2'-bis[N-(4-aminobenzoyl)-3-amino-4-hydroxyphenyl]propane, 9,9-bis(3-amino-4-hydroxyphenyl)fluorene, 9,9-bis[N-(3-aminobenzoyl)-3-amino-4-hydroxyphenyl]fluorene, 9,9-bis[N-(4-aminobenzoyl)-3-amino-4-hydroxyphenyl]fluorene, N,N'-bis(3-aminobenzoyl)-2,5-diamino-1,4-dihydroxybenzene, N,N'-bis(4-aminobenzoyl)-2,5-diamino-1,4-dihydroxybenzene, N,N'-bis(4-aminobenzoyl)-4,4'-diamino-3,3-dihydroxybiphenyl, N,N'-bis(3-aminobenzoyl)-3,3'-diamino-4,4-dihydroxybiphenyl, N,N'-bis(4-aminobenzoyl)-3,3'-diamino-4,4-dihydroxybiphenyl, 3,3'-diamino-4,4'-biphenol, bis(3-amino-4-hydroxyphenyl)methane, 1,1-bis(3-amino-4-hydroxyphenyl) ethane, 2,2-bis(3-amino-4-hydroxyphenyl)propane, 2,2-bis(3-amino-4-hydroxyphenyl) hexafluoropropane, and 2,2-bis[3-(3-aminobenzamido)-4-hydroxyphenyl]hexafluoropropane.

Use of a diamine having an alkylene oxide group or a siloxane structure is preferable because direct bonding can be performed at a low temperature of about room temperature to 100°C. Diamines having a structure represented by the formula (1) described above as the alkylene oxide group are preferable, and examples of commercially available products thereof include ED-600, ED-900, ED-2003, EDR-148, EDR-176, D-200, D-400, D-2000, THF-100, THF-140, THF-170, RE-600, RE-900, RE-2000, RP-405, RP-409, RP-2005, RP-2009, RT-1000, HE-1000, HT-1100, and HT-1700 (trade names, manufactured by HUNTSMAN Corporation). Diamines having a structure represented by the formula (2) described above as the siloxane structure are preferable, and examples of commercially available products thereof specifically include bis(3-aminopropyl)tetramethyldisiloxane, bis(p-aminophenyl)octamethylpentasiloxane, PAM-E, KF-8010, X-22-161A, X-22-161B, KF-8012, KF-8008, X-22-1660B-3, and X-22-9409 (trade names, manufactured by Shin-Etsu Chemical Co., Ltd.).

The polyamine compounds above can be used as it is or as compounds in which an amine moiety is isocyanated or trimethylsilylated. Further, these two or more polyamine compounds may be used in combination.

Further, the weight-average molecular weight of resin can be adjusted or a functional group different from those in a molecule can be introduced by capping a resin terminal with a monoamine, an acid anhydride, an acid chloride, or a monocarboxylic acid.

Preferable examples of the monoamine include 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used.

Preferable examples of the acid anhydride, the acid chloride, and the monocarboxylic acid include acid anhydrides such as phthalic anhydride, maleic anhydride, nadic acid anhydride, cyclohexanedicarboxylic acid anhydride, and 3-hydroxyphthalic acid anhydride, monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, and 1-mercapto-5-carboxynaphthalene, monoacid chloride compounds in which carboxyl groups thereof are converted into an acid chloride, monoacid chloride compounds in which only one carboxyl group of dicarboxylic acids, such as terephthalic acid, phthalic acid, maleic acid, cyclohexanedicarboxylic acid, 1,5-dicarboxynaphthalene, 1,6-dicarboxynaphthalene, 1,7-dicarboxynaphthalene, and 2,6-dicarboxynaphthalene, is converted into an acid chloride, and active ester compounds produced by reacting a monoacid chloride compound with N-hydroxybenzotriazole or N-hydroxy-5-norbornene-2,3-dicarboximide. Two or more of these may be used.

As the polyimide precursors, polyamic acid or polyamide acid esters are preferable, and examples thereof include polyimide precursors containing a structural unit represented by formula (3).

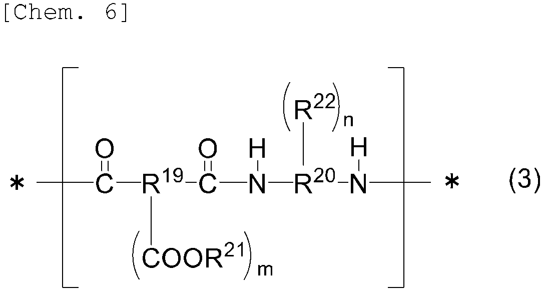

In the formula (3), R¹⁹ represents an organic group having a valence of 4 to 6, and R²⁰ represents an organic group having a valence of 2 to 10. A plurality of R²²s each independently represent an organic group having 1 to 10 carbon atoms or a hydroxy group, and n represents an integer of 0 to 8. A plurality of R²¹s may be the same or different and represent a hydrogen atom or a monovalent organic group having 1 to 30 carbon atoms. m represents an integer 2 to 4. R¹⁹-(COOR²¹)ₘ represents the aforementioned tetracarboxylic acid and/or a derivative residue thereof. R²⁰-(R²²)ₙ represents the aforementioned diamine and/or a derivative residue thereof. Sign * represents a point of bonding. Examples of the organic group having 1 to 30 carbon atoms of R²¹ include hydrocarbon groups such as a methyl group, an ethyl group, a n-propyl group, an i-propyl group, a n-butyl group, a t-butyl group, a n-pentyl group, a neopentyl group, a n-hexyl group, a s-hexyl group, a n-heptyl group, a n-octyl group, and a s-octyl group; alkylene oxide groups such as a 2-methoxyethyl group, a 2-methoxypropyl group, a diethylene glycol methyl group, and a dipropylene glycol methyl group; and unsaturated bond-containing organic groups such as an ethyl 2-(meth)acrylate group, a propyl 2-(meth)acrylate group, a butyl 2-(meth)acrylate group, an allyl group, and a butenyl group.

Examples of the polyimide include products obtained by cyclodehydrating a polyamic acid, a polyamide acid ester, a polyamic acid amide, or a polyisoimide described above by a reaction with heat, an acid, a base, or the like. The polyimide has a tetracarboxylic acid and/or its derivative residue and a diamine and/or its derivative residue. To form a polyimide as the (B) resin layer on the first substrate or the second substrate, a method of applying a polyimide precursor solution onto a substrate, drying the polyimide precursor solution, and heating the residue to a temperature equal to or more than imidization is the most simple and preferable.

Examples of the polyimide include a polyimide containing a structural unit represented by the following formula (4).

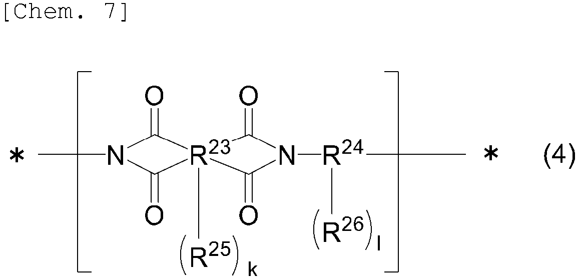

In the formula (4), R²³ represents an organic group having a valence of 4 to 10, and R²⁴ represents an organic group having a valence of 2 to 8. R²⁵ and R²⁶ each represent a hydroxy group or an organic group having 1 to 20 carbon atoms, and each may be the same type of group at every occurrence or may include different groups. k and 1 each represent an integer of 0 to 6. R²³-(R²⁵)ₖ represents the aforementioned tetracarboxylic acid and/or a derivative residue thereof. R²⁴-(R²⁶)₁ represents the aforementioned diamine and/or a derivative residue thereof. Among them, from the viewpoint of adhesive force at the time of direct bonding, a diamine residue having an alkylene oxide group or a siloxane linkage is preferable. Sign * represents a point of bonding.

Examples of the polybenzoxazole precursor include polyhydroxyamides obtained by reacting a dicarboxylic acid and a derivative thereof with a bisaminophenol compound or the like as a diamine.

Examples of the dicarboxylic acid include terephthalic acid, isophthalic acid, dimer acid, diphenyl ether dicarboxylic acid, bis(carboxyphenyl)hexafluoropropane, biphenyl dicarboxylic acid, benzophenone dicarboxylic acid, and triphenyl dicarboxylic acid, and examples of tricarboxylic acid include trimellitic acid, trimesic acid, diphenyl ether tricarboxylic acid, and biphenyl tricarboxylic acid. These compounds may be used singly or two or more of them may be used in combination. In particular, from the viewpoint of reducing the dielectric dissipation factor, the dimer acid is preferable.

Examples of the bisaminophenol include the bisaminophenol compounds enumerated as examples for the polyimide precursor.

Examples of the polybenzoxazole precursor to be used in the present invention include those containing a structural unit represented by the following formula (5).

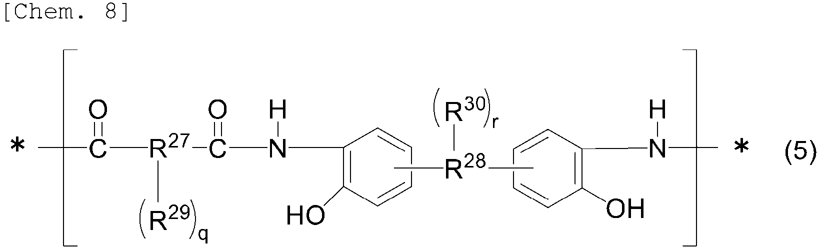

In the formula (5), R²⁷ represents an organic group having a valence of 2 to 6, and R²⁸ represents a single bond or an organic group having a valence of 2 to 6. R²⁹ and R³⁰ each represent an organic group having 1 to 10 carbon atoms or a hydroxy group. q and r each represent an integer of 0 to 4. R²⁷-(R²⁹)_{q} represents the aforementioned dicarboxylic acid and/or a derivative residue thereof. In particular, a dimer acid residue is preferable from the viewpoint of low dielectric dissipation factor. R²⁸-(R³⁰)ᵣ represents the aforementioned bisaminophenol compound and/or a derivative residue thereof. Sign * represents a point of bonding.

Examples of the polybenzoxazole include a polybenzoxazole obtained by cyclodehydrating a dicarboxylic acid and a bisaminophenol compound as a diamine based on a reaction using a polyphosphoric acid, and a polybenzoxazole precursor obtained by cyclodehydrating the polyhydroxyamide by heating or a reaction using a phosphoric anhydride, a base, a carbodiimide compound, or the like.

Examples of the polybenzoxazole include those containing a structural unit represented by formula (6).

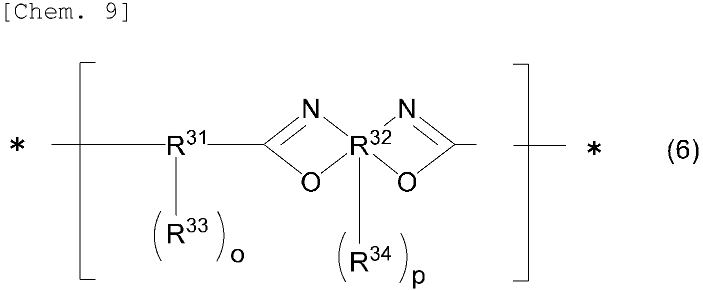

In the formula (6), R³¹ represents an organic group having a valence of 2 to 6, and R³² represents an organic group having a valence of 4 to 6. R³³ and R³⁴ each independently represent an organic group having 1 to 10 carbon atoms or a hydroxy group. o represents an integer of 0 to 4, and p represents an integer of 0 to 2. R³¹-(R³³)ₒ represents the aforementioned dicarboxylic acid and/or a derivative residue thereof. In particular, a dimer acid residue is preferable from the viewpoint of low dielectric dissipation factor. R³²-(R³⁴)ₚ represents the aforementioned bisaminophenol compound and/or a derivative residue thereof. Sign * represents a point of bonding.

Examples of the polyamide include those obtained by dehydration condensation of a dicarboxylic acid and a diamine compound based on a reaction using polyphosphoric acid.

Examples of the polyamide include a polyamide containing a structural unit represented by the following formula (7).

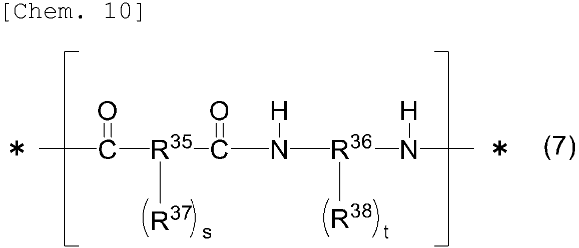

In the formula (7), R³⁵ and R³⁶ each represent an organic group having a valence of 2 to 6. R³⁷ and R³⁸ each independently represent an organic group having 1 to 10 carbon atoms or a hydroxy group. s represents an integer of 0 to 4, and t represents an integer of 0 to 4. R³⁵-(R³⁷)ₛ represents the aforementioned dicarboxylic acid and/or a derivative residue thereof, and R³⁶-(R³⁸)ₜ represents a diamine compound excluding the aforementioned bisaminophenol compound and/or a derivative residue thereof. Sign * represents a point of bonding.

Further, the (B) resin layer may contain a copolymer composed of two or more substances selected from the group consisting of polyimides, polyimide precursors, polybenzoxazoles, polybenzoxazole precursors, polyamides, polyurethanes, and polyureas.

Examples of the polyurea include those obtained by a polyaddition reaction of a diamine and a polyfunctional isocyanate.

Examples of the diamine include the compounds enumerated as examples for the polyimide, the polybenzoxazole, and the polyamide. Preferable examples are also the same as those recited for the polyimide, the polybenzoxazole, and the polyamide.

Examples of the polyfunctional isocyanate include hexamethylene diisocyanate, 1,3-bis(isocyanatomethyl)benzene, 1,3-bis(isocyanatomethyl)cyclohexane, norbornene diisocyanate, naphthalene-1,5-disocyanate, diphenylmethane-4,4'-diisocyanate, toluene-2,4-diisocyanate, and the like, and examples of the polyol include ethylene glycol, propylene glycol, pentaerythritol, dipentaerythritol, 1,4-bis(2-hydroxyethoxy) benzene, 1,3-bis(2-hydroxyethoxy)benzene, 4,4'-bis(2-hydroxyethoxy)biphenyl, 2,2-bis(4-(2-hydroxyethoxy) phenyl) propane, and bis(4-(2-hydroxyethoxy)phenyl)methane.

A polyaddition reaction product of a diamine and a polyfunctional isocyanate can be obtained without a catalyst, but a catalyst may be used. Examples of the catalyst include tin compounds such as dibutyltin dilaurate and tertiary amines such as 1,4-diazabicyclo[2.2.2]octane.

As the polyester, a polyester obtained through a polyaddition reaction of a polyol compound and an acid dianhydride is preferable because it is easily synthesized and has few side reactions. As the polyol compound, a compound obtained by a reaction between a polyfunctional epoxy compound and a radical polymerizable group-containing monobasic acid compound such as (meth)acrylic acid is preferable because it is easy to introduce a radical polymerizable group and an aromatic ring.

Examples of the polyfunctional epoxy compound include, but are not limited to, aliphatic epoxy compounds such as ethylene glycol diglycidyl ether, neopentyl glycol diglycidyl ether, or hydrogenated bisphenol-A-diglycidyl ether, or aromatic epoxy compounds such as 9,9-bis(4-glycidyloxyphenyl) fluorene.

Further, examples of other polyol compounds include aliphatic alcohol compounds such as ethylene glycol, propylene glycol, butylene glycol, glycerin, trimethylolpropane, and pentaerythritol, and 9,9-bis[4-(2-hydroxyethoxy)phenyl]fluorene.

Examples of the acid dianhydride include the tetracarboxylic acid dianhydrides enumerated as examples in the description of the polyimide precursor.

Examples of the polyurethane include those obtained by a polyaddition reaction of a polyol compound and a polyfunctional isocyanate. Examples of the polyol compound include the compounds enumerated as examples for the polyester. Examples of the polyfunctional isocyanates include the compounds enumerated as examples for the polyurea. A catalyst may be used for the polyaddition reaction, and examples of the catalyst include the compounds enumerated as examples for the polyurea.

The laminate of the present invention may have a (C) inorganic insulating layer. That is, the second substrate may include an exposed (A-2) metal electrode and an exposed (C) inorganic insulating layer. As the (C) inorganic insulating layer, an inorganic insulating layer of silicon oxide (SiO₂), silicon nitride (SiN), silicon nitride carbide (SiCN), silicon nitride oxide (SiON), titanium oxide (TiO₂), zirconium oxide (ZrO₂), aluminum oxide (Al₂O₃), or the like can be used. In addition, the (C) inorganic insulating layer may be a laminate of these layers. Among them, an inorganic insulating layer including SiO₂, SiN, or SiCN is preferable from the viewpoint of insulating properties and economic efficiency (cost).

Among the examples described above, the (B) resin layer preferably contains a resin having a group represented by the formula (1) or the formula (2). That is, it is preferable that at least one of the (B-1) resin layer and the (B-2) resin layer contains a resin having an alkylene oxide group, and the alkylene oxide group is a group represented by the formula (1). In addition, it is preferable that at least one of the (B-1) resin layer and the (B-2) resin layer contains a resin having a group having a siloxane linkage, and the group having a siloxane linkage is a group represented by the formula (2).

From the viewpoint of substrate adhesiveness, bonding strength, and processability, the (B) resin layer preferably contains one or more resins which are selected from the group consisting of polyimide, polyimide precursors, polybenzoxazole, polybenzoxazole precursors, polyamide excluding the polyimide precursors and the polybenzoxazole precursors, and copolymers thereof and which have a group represented by the formula (1) or the formula (2) among the examples previously described. That is, at least one of the (B-1) resin layer and the (B-2) resin layer preferably contains one or more resins which are selected from the group consisting of polyimide, polyimide precursors, polybenzoxazole, polybenzoxazole precursors, polyamide excluding the polyimide precursors and the polybenzoxazole precursors, and copolymers thereof and which have a group represented by the formula (1) or the formula (2).

It is preferable that the resin contained in at least one of the (B-1) resin layer and the (B-2) resin layer contains two or more structures represented by the formula (9) because the coefficient of thermal expansion can be kept low. 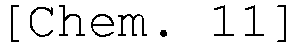 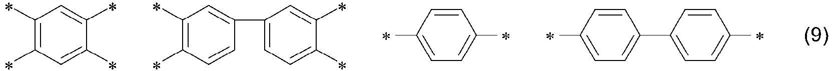 wherein sign * represents a bonding site; R¹² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.

Examples of the acid dianhydride to afford the acid dianhydride residue represented by the formula (9) include pyromellitic dianhydride and 3,3',4,4'-biphenyltetracarboxylic dianhydride.

Examples of the diamine to afford the diamine residue represented by the formula (9) include p-phenylenediamine, benzidine, 4,4'-bis(4-aminophenoxy)biphenyl, 4,4'-[[1,1'-biphenyl]-4,4'-diylbis(oxy)]bis(3-methylaniline), and 4,4'-[[1,1'-biphenyl]-4,4'-diylbis(oxy)]bis[3-(trifluoromethyl)aniline].

Acid dianhydrides to afford the acid dianhydride residues represented by the formula (9) or diamines to afford the diamine residues represented by the formula (9) may have a substituent. Examples of the acid dianhydrides to afford the acid dianhydride residues represented by the formula (9) or the diamines to afford the diamine residues represented by the formula (9) include 2,5-diaminotoluene, 2,5-dimethyl-1,4-phenylenediamine, 2-(trifluoromethyl)-1,4-phenylenediamine, 2,3,5,6-tetrafluoro-1,4-phenylenediamine, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 2,2',5,5'-tetramethyl-4,4'-diaminobiphenyl, 3,3',5,5'-tetramethyl-4,4'-diaminobiphenyl, 4,4'-diaminooctafluorobiphenyl, 3,3'-dihydroxybenzidine, and 1,4-diamino-5-dicarboxybenzene.

The coefficient of thermal expansion of at least one of the (B-1) resin layer and the (B-2) resin layer in a temperature range of 50°C to 150°C is preferably 10 ppm/K or more and 40 ppm/K or less, more preferably 15 ppm/K or more and 30 ppm/K or less, and still more preferably 20 ppm/K or more and 25 ppm/K or less. Within such a range, the difference in thermal expansion coefficient from copper is reduced, and the reliability of the laminate after bonding is easily obtained.

The laminate preferably further contains an antioxidant in at least one of the (B-1) resin layer and the (B-2) resin layer. By containing the antioxidant, oxidative degradation of the resin to be mixed is suppressed. In addition, due to the rust prevention action on a metal material, metal oxidation by moisture or the like from the outside, and accompanying reduction in adhesion and peeling can be suppressed. These actions improve the long-term reliability of the laminate.

As the antioxidant, a hindered phenol antioxidant-based or a hindered amine-based antioxidant is preferred. In addition, the number of phenol groups or amino groups in one molecule is preferably 2 or more, and more preferably 4 or more because they easily achieve an antioxidant effect, and among them, a compound represented by the following formula (8) is preferable. Containing the compound represented by the formula (8) makes it possible to suppress mechanical properties and peeling from a metal material in a cured film after a reliability test such as a high temperature preservability test.

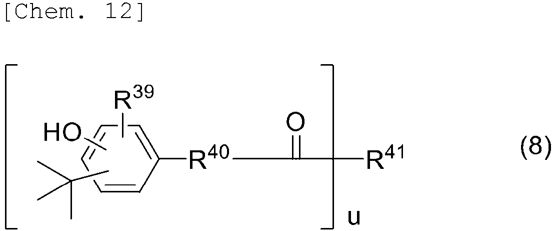

In the formula (8), R³⁹ represents a hydrogen atom or an alkyl group having 2 or more carbon atoms, and R⁴⁰ represents an alkylene group having 2 or more carbon atoms. R⁴¹ represents an organic group having a valence of 1 to 4 and containing at least one among an alkylene group having 2 or more carbon atoms, an O atom, and an N atom. u represents an integer 1 to 4.

Examples of the monovalent organic group suitable as R⁴¹ include alkyl groups, cycloalkyl groups, alkoxy groups, alkyl ether groups, alkylsilyl groups, alkoxysilyl groups, aryl groups, aryl ether groups, a carboxyl group, an allyl group, a vinyl group, and heterocyclic groups, and examples of the divalent organic group include a carbonyl group, - O-, -NH-, -NHNH-, -NHCO-, and -COO-. Examples of the trivalent or tetravalent organic group suitable as R⁴¹ include groups each resulting from replacement of a hydrogen atom of the monovalent or divalent organic group described above with a bonding point. Additional examples include a combination of those groups, which may further have a substituent.

Examples of the compound represented by the formula (8) include, but are not limited to, the following compounds.

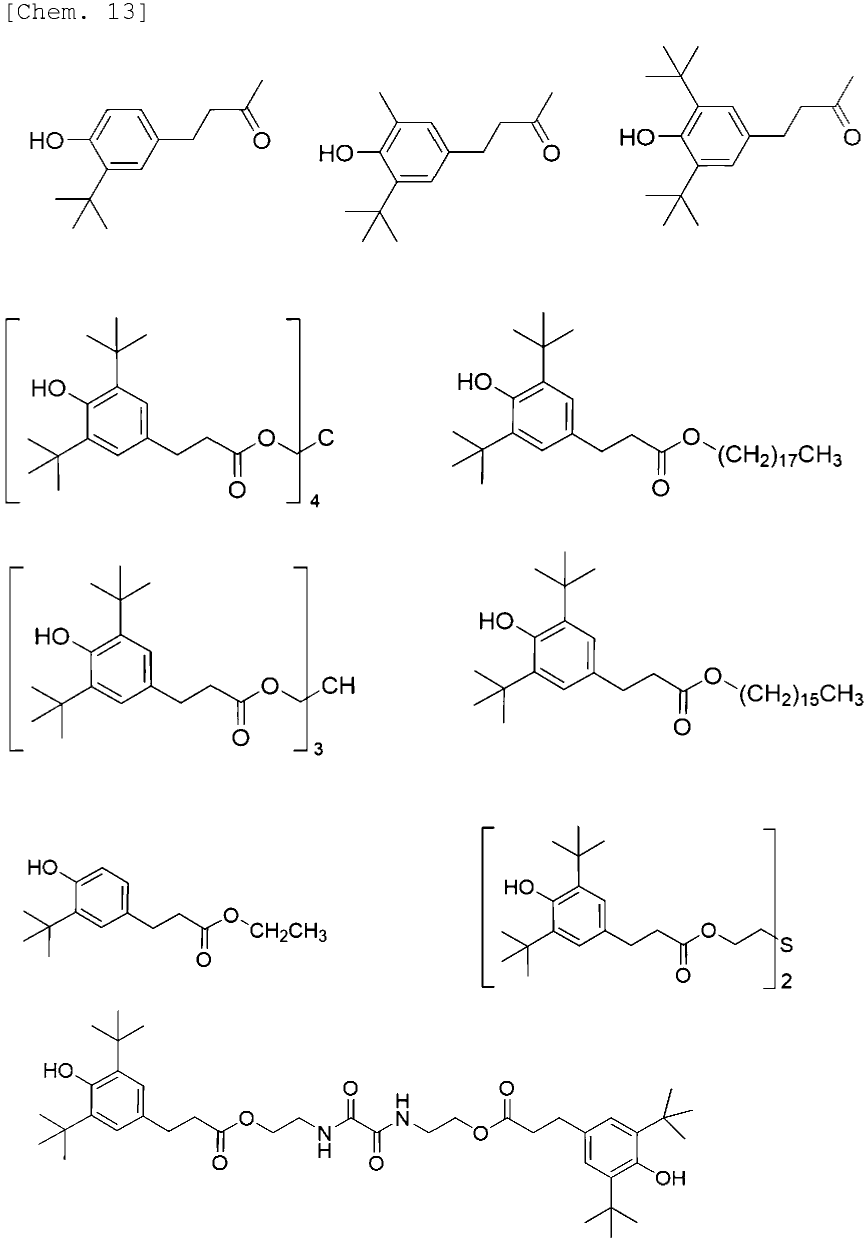

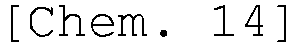

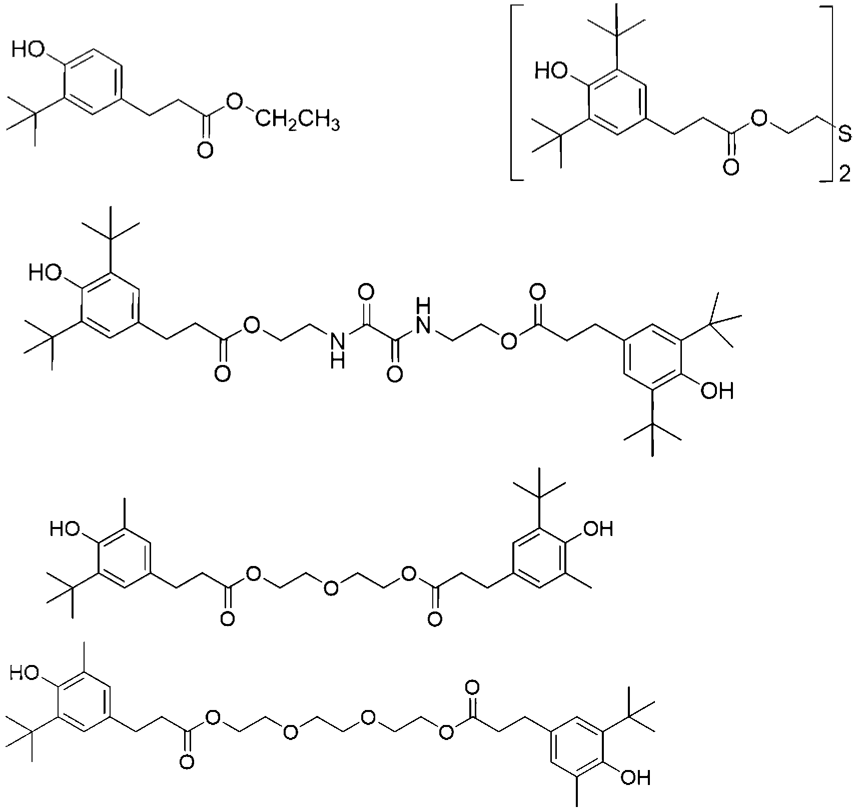

The method for forming the (B) resin layer is not particularly limited, but the (B) resin layer can be formed from, for example, a resin composition containing one or resins among at least a carbonyl group, a hydroxy group, an alkylene oxide group, a group having a siloxane linkage, and a nitrogen-containing heterocyclic ring and a solvent, and the resin composition is preferably in a liquid form or a sheet form. In the case of a liquid form, the (B) resin layer can be obtained through a drying step in which the resin composition is applied onto a substrate body by a known method such as spin coating, slit die coating, spray coating, or inkjet coating, and then the coating film is dried by heating with a hot plate, an oven, infrared rays, or the like. In the case of a sheet form, the (B) resin layer can be formed by lamination. After the lamination, a drying step may be similarly performed. In addition, the (B) resin layer may be cured by at least one treatment of light and heat, as necessary, as long as the characteristics as the (B) resin layer are not impaired. In the case of curing by heat, the curing temperature may be appropriately selected in the range of 100°C or more and 400°C or less, and the curing time may be selected from 3 minutes to 3 hours according to the purpose. In particular, annealing in the range of 150°C or more and 250°C or less is preferable because the load on the substrate body is small. When the resin composition has photosensitivity, a pattern such as a via hole may be formed in the (B) resin layer through exposure to light and development steps, as necessary.

The elastic modulus of at least one of the (B-1) resin layer and the (B-2) resin layer is preferably 1.5 GPa or more and 7 GPa or less, and more preferably 2.5 GPa or more and 5 GPa or less. Within such a range, it is easy to obtain high adhesive strength and reliability while suppressing generation of voids due to minute foreign matters of dicing.

At least one of the (B-1) resin layer and the (B-2) resin layer may form a crosslinked structure. The elastic modulus can be increased by forming the crosslinked structure. The crosslinked structure can be formed by making the resin composition contain a crosslinking agent and subjecting the resulting resin composition to curing treatment. Examples of the crosslinking agent include, but are not limited to, a methylol compound, an epoxy compound, and an oxetane compound.

As the epoxy compound, known epoxy compounds may be contained, and examples thereof specifically include those enumerated as examples in the description of the epoxy resin.

As the oxetane compound, a known oxetane compound may be contained. Examples thereof include OXT-101, OXT-121, OXT-212, and OXT-221 (trade names, manufactured by TOAGOSEI CO., LTD.), ETERNACOLL EHO, ETERNACOLL OXBP, ETERNACOLL OXTP, ETERNACOLL OXMA, ETERNACOLL OXIPA (trade names, manufactured by UBE Corporation), and oxetanized phenol novolac.

As the methylol compound, a known methylol compound may be contained. Preferable examples of the compound include DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (trade names, manufactured by Honshu Chemical Industry Co., Ltd.), NIKALAC (registered trademark) MX-290, NIKALAC MX-280, NIKALAC MX-270, NIKALAC MX-279, NIKALAC MW-100LM, and NIKALAC MX-750LM (trade names, manufactured by Sanwa Chemical Co., Ltd.).

At least one of the (B-1) resin layer and the (B-2) resin layer also may be formed from a resin composition containing a photosensitive agent. Forming from a photosensitive material can simplify a method for producing the first substrate and the second substrate, and makes it possible to control the elastic modulus through promotion of the reaction of the crosslinking agent. As the photosensitive agent, a photopolymerization initiator or a photoacid generator is preferable. In particular, a material containing a photoacid generator is preferable from the viewpoint of resolution. Specific examples of the photopolymerization initiator and the photoacid generator include the same ones as those described in JP 2018-165819 A. Preferable examples are also the same as those described therein.

The first substrate and the second substrate of the laminate of the present invention each have a substrate body. The substrate body refers to, for example in the first substrate, a plate-like article other than the (A-1) metal electrode and the (B-1) resin layer. At least one of the substrate body of the first substrate and the substrate body of the second substrate preferably contains one or more selected from the group consisting of silicon, niobium lithate, tantalum lithate, gallium nitride, silicon carbide, gallium arsenide, and indium phosphide. Silicon is suitably used for a semiconductor element having functions such as arithmetic processing, information storage, and power control. Niobium lithate and tantalum lithate are suitably used for MEMS elements having an electric signal filtering function. Gallium nitride and silicon carbide are suitably used for semiconductor elements having a power control function, and gallium arsenide and indium phosphide are suitably used for semiconductor elements having light receiving and light emitting functions.

The bonding strength between the first substrate and the second substrate of the laminate of the present invention in a die shear test can be used when the bonding strength is 5 MPa or more, and from the viewpoint of reliability, the bonding strength is preferably 10 MPa or more, and more preferably 20 MPa or more.

A method for producing the laminate of the present invention will be described. As a production method, for example, a technique known in the industry can be used in which direct bonding between wafers having SiO₂ and copper provided on the same face is performed (Materials 2022, 15(5), 1888, etc.). In this technique, before direct bonding is performed, two wafer surfaces are smoothed at an atomic level by chemical mechanical polishing (CMP), and then the surfaces are activated by plasma treatment and directly bonded by a bonding process. Also in the direct bonding in the present invention, the above-described technique known in the industry can be applied.

In the first substrate and the second substrate before the preparation of the laminate, a substrate on which a circuit of a passive component and/or an active component is formed can be used as a substrate body. By using such a substrate body, the resulting laminate has a function as a semiconductor and/or MEMS.

The semiconductor element of the present invention is a semiconductor element including the laminate of the present invention. Further, the MEMS element of the present invention is an MEMS element including the laminate of the present invention. In addition, these each may be a composite element including a laminate in which two substrate bodies have a semiconductor function and an MEMS function, respectively. The first substrate and the second substrate are obtained by forming an (A) metal electrode and a (B) resin layer on each of the substrate bodies, followed by smoothing. The metal electrode (A) can be formed by a known method, and examples of the method include a subtract process and a semi-additive process. Formation of a copper electrode by the semi-additive process will be described as a specific example. A seed layer of Ti, Ni, or the like is formed on a substrate body by sputtering, a dry film resist is patterned, a copper electrode pattern is formed by electrolytic plating, and then the resist is removed. Then, through a subsequent step of seed layer removal, a copper electrode pattern can be formed. Thereafter, a resin layer is formed by the method for forming (B) resin layer described above. As a result, a substrate including the (A) metal electrode and the (B) resin layer provided on the same face is obtained.

Each of the (A) metal electrode and the (B) resin layer can be exposed by smoothing the substrate including the (A) metal electrode and the (B) resin layer. Thus, the first substrate and the second substrate are obtained. In the smoothing step, it is preferable to use a surface planer using CMP or a diamond bite. CMP is preferable because it can reduce the surface roughness and increase the bonding strength. In addition, a step of performing CMP after performing the surface planer is preferable from the viewpoint of shortening the process time.

The first substrate and the second substrate smoothed are each preferably activated by plasma treatment on the face on which the (A) metal electrode and the (B) resin layer are provided. By the activation, the bonding strength can be increased. The plasma treatment is performed using an inert gas for plasma, and the oxygen volume concentration is preferably 1% or less, more preferably 0.1% or less, and still more preferably 0.01% or less. By adjusting the oxygen volume concentration to less than 1%, it is possible to suppress the oxidation of the metal electrode as the outermost layer to maintain conductivity, and also possible to suppress the oxidation of the resin layer to suppress a decrease in bonding force. Examples of the inert gas to be used for the plasma treatment include argon and helium, and to maintain the activated state for a long time after the treatment, helium is preferably contained as the inert gas to be turned into plasma. Since the activation energy of helium is low, the activation energy state of the resin layer activated by helium plasma is low and becomes a relatively stable state. Therefore, the activation state is elongated, a time delay from the plasma treatment to direct bonding is secured, and the process margin is improved. Examples of plasma processing for direct bonding containing helium are shown in Wafer Level Package Symposium 2022 "Atmospheric Plasma System for In-Line Surface Activation of Die-to-Wafer Direct and Hybrid Bonding" presentation and the like, and this technique can also be used in the present invention.

As a method of bonding the first substrate and the second substrate, wafer to wafer (W2W), which is bonding of wafers using a wafer bonder, chip to wafer (C2W), by which chips are bonded to wafers, or chip to chip (C2C), by which chips are bonded to each other, may be used. Among them, C2W is preferable from the viewpoint of bonding accuracy, ease of circuit design, etc. For bonding using a chip, a flip chip bonder or the like is used. The chip is obtained through a wafer singulation step by dicing. The C2W laminate can be produced by, for example, preparing a plurality of singulated pieces of a first substrate by dicing, and directly bonding the plurality of pieces of the first substrate on a second substrate side by side. That is, it is preferable that a plurality of singulated pieces of the first substrate is directly bonded onto the same face of the second substrate. Further, after the singulated pieces of the first substrate is bonded to the second substrate, an exposed metal electrode and an exposed resin layer on a face opposite from the bonded face are formed (alternatively, on both faces of the first substrate may be formed in advance an exposed metal electrode and an exposed resin layer), and then may be bonded to another first substrate such that the substrates are vertically arranged. In this way, it is possible to stack a large number of chips at a high density. The plurality of pieces of the first substrate may be the same or different in size.

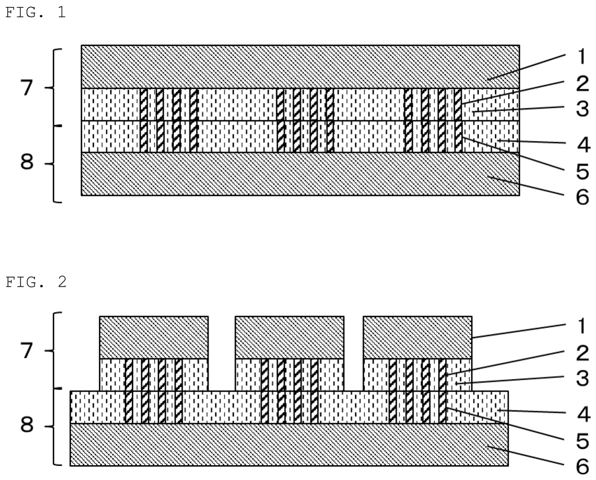

The temperature of the bonding stage at the time of bonding and the temperature of the bonding head that holds the other substrate are both preferably 20°C to 40°C. Fig. 1 shows a sectional view of a laminate obtained by W2W, and Fig. 2 shows a sectional view of a laminate obtained by C2W.

After the bonding, it is preferable to perform annealing treatment. By performing the annealing treatment, the bonding strength is enhanced by softening of the resin layer and diffusion of the metal electrode, and the reliability of the resulting laminate is improved. The annealing temperature may be appropriately selected from 100°C to 350°C, and the annealing time can be selected from 3 minutes to 3 hours according to the purpose. In particular, annealing in the range of 150°C to 250°C is preferable because the load on the substrate bodies is small.

When a photosensitive resin composition is used for the formation of a (B) resin layer, an (A) metal wiring and a (B) resin layer can be formed through a process different from that described above. First, the photosensitive resin composition is applied to a substrate body, dried, exposed to light, developed, and cured to form a (B) resin layer having a pattern. Thereafter, a seed layer of Ti, Ni, or the like is formed by sputtering, a dry film resist is patterned such that the same portions as the openings of the underlying (B) resin layer are opened, and a copper electrode pattern is formed by electrolytic plating. Next, resist removal and seed layer removal are performed to afford a substrate having the exposed (A) metal electrode and the exposed (B) resin layer on the same face. Thereafter, bonding can be performed through the smoothing step and the activation step. Further, since the (A) metal electrode and the (B) resin layer have already been exposed, they may be bonded as they are.

### EXAMPLES

The present invention will be illustrated below with reference to Examples, but it should be understood that the present invention is not construed as being limited thereto.

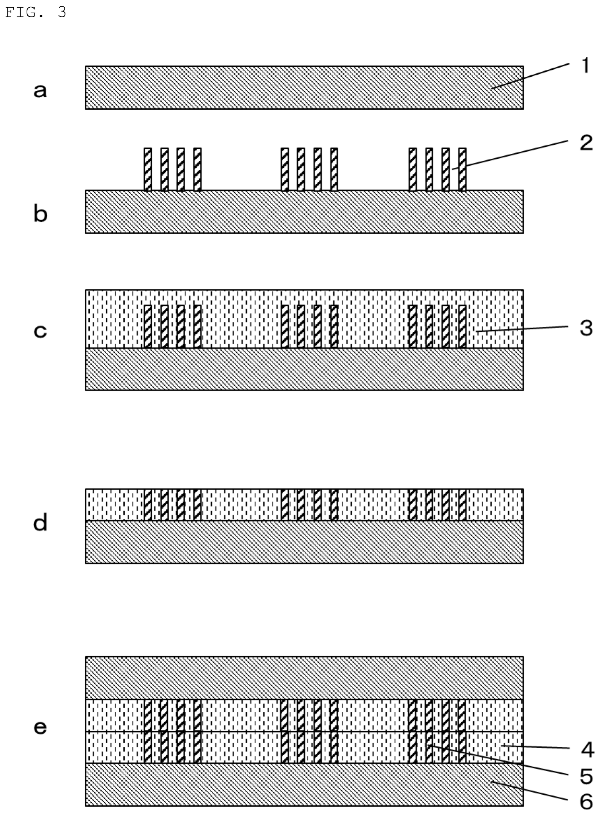

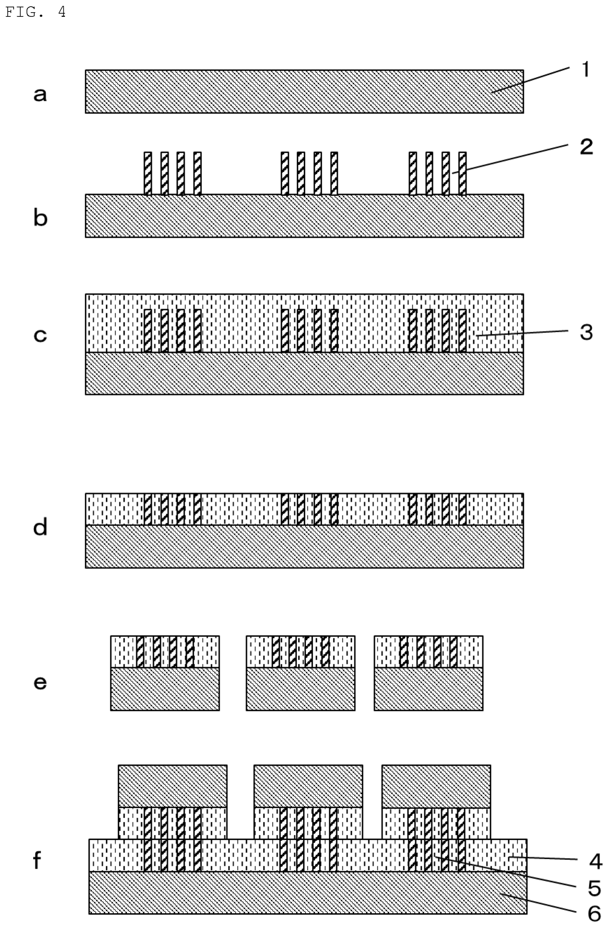

First, a method for preparing a laminate, a method for measuring physical properties of a resin layer and a resin composition will be described. Steps of preparing a laminate are shown in Figs. 3 and 4.

### <Preparation of Substrate>

### (1) Preparation of Substrate with Cu Pad and Resin Layer

### (1-1) Formation of Metal Electrode

A Ti/Cu seed layer was formed on an 8-inch silicon wafer by sputtering, a commercially available dry film resist for plating was laminated, patterning was performed, and via processing (5 rows × 5 columns) with 5 µmφ and a pitch of 10 µm was performed. Thereafter, Cu having a height of 3 µm was formed by electroplating. Thereafter, the resist was removed with a peeling solution, and the seed layer was further removed with an etchant, whereby a Cu pad with 5 µmφ and a height of 3 µm was formed on the 8-inch silicon wafer (see Fig. 3-b and Fig. 4-b).

### (1-2) Formation of Resin Layer

The resin composition obtained in the adjustment example described later was spin-coated (1000 rpm, 30 sec) on the wafer with a Cu pad described above, prebaked (at 120°C for 3 minutes), and cured (at 230°C for 1 hour, O₂ concentration; 20 vol ppm), affording a resin layer having a thickness of 4 µm. It is noted that when a polyimide precursor was used, curing was performed at 300°C (See Fig. 3-c and Fig. 4-c).

### (2) Planarization of Substrate

Chemical mechanical polishing (CMP) treatment of the substrate with a Cu pad and a resin layer prepared in (1-2) was performed using a silica slurry and a urethane polishing pad (See Fig. 3-d and Fig. 4-d).

By this step, a first substrate and a second substrate each including an exposed (A) metal electrode and an exposed (B) resin layer provided on the same face of a substrate body were obtained.

### (3) Singulation of substrate

The first substrate was singulated (1 mm□) using a DAD3240 Dicing Saw (manufactured by DISCO Corporation) (See Fig. 4-e).

### (4) Activation of Substrate

Plasma treatment of the first substrate and the second substrate was performed with 98 vol% of N₂ and 2 vol% of He using an atmospheric plasma system (manufactured by Ontos Equipment System). The total gas flow rate was set to 15 slpm, the power was set to 80 W, the interval between the substrate faces of the plasma device was set to 1 mm, and the speed of the plasma device was set to 1 mm/sec.

### (5) Preparation of Laminate

### (5-1) Preparation of W2W Laminate

The first substrate and the second substrate subjected to the plasma treatment in (4) (noted that the first substrate had not been singulated) were W2W bonded at room temperature, a pressure of 8 MPa and a degree of vacuum of 50 Pa for 3 minutes using a vacuum press VACUUM STAR (manufactured by Mikado Technos Co., Ltd.) with the faces on which the (A) metal electrode and the (B) resin layer were exposed facing each other. Thereafter, annealing treatment was performed at 250°C for 1 hour under a nitrogen atmosphere (See Fig. 3-e).

### (5-2) Preparation of C2W Laminate

A chip (the first substrate) singulated in (3) and activated in (4) and a wafer (the second substrate) planarized in (2) and activated in (4) were prepared, and the chip was bonded to the wafer at room temperature and 10 N for 3 seconds using a Flip Lip Bonder FC-3000S (manufactured by Toray Engineering Co., Ltd.). Thereafter, annealing treatment was performed at 250°C for 1 hour (See Fig. 4-f).

### (6) Measurement of Adhesive Force of Laminate

### (6-1) Measurement of Adhesive Force of W2W Laminate

Using a DAD3240 Dicing Saw (manufactured by DISCO Corporation), only the first substrate part of the laminate prepared in (5-1) was cut such that five singulated chips of 1 mm square would be obtained (the second substrate was kept in the original shape of the substrate). A razor blade was inserted from an end of the laminate, and the first substrate was peeled off from the second substrate such that only the singulated chips would be left. For each chip remaining on the second substrate, a force from the lateral direction was applied to the chip using a die shear analyzer (Series 4000 manufactured by DAGE), and the force applied when the chip was peeled off was measured. The measured value was converted into an adhesive force per unit area by dividing the measured value by the area of the chip, and the average value of five resulting values was taken as the adhesive force of the W2W laminate. Furthermore, the same sample was subjected to PCT treatment for 100 hours under conditions of 121°C, 2 atm, and RH100% using a pressure cooker test (PCT) apparatus (HAST CHAMBER EHS-211MD manufactured by Tabai Espec Corp.), and subsequently subjected to a die shear test.

### (6-2) Measurement of Adhesive Force of C2W Laminate

For each of the five chips (pieces of the first substrate) in the C2W laminate prepared in (4), a force from the lateral direction was applied to the chip using a die shear analyzer (Series 4000 manufactured by DAGE), and the force applied when the chip was peeled off was measured. The measured value was converted into an adhesive force per unit area by dividing the measured value by the area of the chip, and the average value of five resulting values was taken as the adhesive force of the C2W laminate. Furthermore, the same sample was subjected to PCT treatment for 100 hours under conditions of 121°C, 2 atm, and RH100% using a pressure cooker test (PCT) apparatus (HAST CHAMBER EHS-211MD manufactured by Tabai Espec Corp.), and subsequently subjected to a die shear test.

### (7) Test of Laminate Reliability

### (7-1) High Temperature Storage (HTS) Test

The laminate prepared in (5-1) or (5-2) was treated at 175°C for 200 hours using a hot air oven.

The laminate after the treatment was sectionally cut with an ion milling system (IM4000 manufactured by Hitachi High-Technologies Corporation), followed by sectional observation with a scanning electron microscope (SEM, S-3000N manufactured by Hitachi High-Technologies Corporation), whereby the condition of the occurrence of peeling was confirmed. As an evaluation method, the degree of peeling of the metal wiring was observed, and where peeling 0% was rated as 4, peeling more than 0% and less than 25% was rated as 3, peeling 25% or more and less than 50% was rated as 2, and peeling 50% or more was rated as 1, and the rating of 2 or more was regarded as acceptable.

### (7-2) Thermal Cycle (TC) Test

The laminate prepared in (5-1) or (5-2) was subjected to 500 cycles of treatment at -45°C for 15 minutes and at 125°C for 15 minutes per cycle using a thermal cycle tester (hereinafter referred to as "TC apparatus") (manufactured by Tabai Espec Corp.).

The laminate after the treatment was sectionally cut with an ion milling apparatus, followed by sectional observation with a scanning electron microscope, whereby the condition of the occurrence of cracks was confirmed. As an evaluation method, the degree of cracks in the resin layer was observed, and where the occurrence of 0 cracks was rated as 4, the occurrence of 1 to 3 cracks was rated as 3, the occurrence of 4 to 10 cracks was rated as 2, and the occurrence of 11 or more cracks was rated as 1, and the rating of 2 or more was regarded as acceptable.

### (8) Measurement of Elastic Modulus

A resin composition was applied onto a 6-inch silicon wafer by a spin coating method and prebaked using a coater and developer Mark-7 such that the film thickness after prebaking at 120°C for 3 minutes was 5 µm. Then, when the resin composition used was a resin composition containing a photosensitive component (photoacid generator), the entire surface of the prebaked product was exposed to light at 300 mJ/cm² using a PLA, and the temperature was raised to 220°C at 3.5°C/min at an oxygen concentration of 20 ppm or less using an inert oven CLH-21CD-S (manufactured by Koyo Thermo Systems Co., Ltd.), and heat treatment was performed for 1 hour. when the resin composition used was a resin composition containing no photosensitive component, the prebaked product as received was subjected to that raising of the temperature and the subsequent heat treatment. The heat cured wafer was cut into a size of 5 cm square, and the elastic modulus was measured using a nanoindenter (Triboindenter TI 950 manufactured by Hysitron, Inc.). The obtained value was taken as the elastic modulus of the resin layer.

### (9) Measurement of Coefficient of Thermal Expansion (CTE)

A resin composition was applied onto a 6-inch silicon wafer by a spin coating method and prebaked using a coater and developer Mark-7 such that the film thickness after prebaking at 120°C for 3 minutes was 10 µm. Then, when the resin composition used was a resin composition containing a photosensitive component (photoacid generator), the entire surface of the prebaked product was exposed to light at 300 mJ/cm² using a PLA, and the temperature was raised to 220°C at 3.5°C/min at an oxygen concentration of 20 ppm or less using an inert oven CLH-21CD-S (manufactured by Koyo Thermo Systems Co., Ltd.), and heat treatment was performed for 1 hour. when the resin composition used was a resin composition containing no photosensitive component, the prebaked product as received was subjected to that raising of the temperature and the subsequent heat treatment. When the temperature reached 50°C or less, the wafer was taken out and immersed in 45% by mass of hydrofluoric acid for 1 minutes, whereby the cured film was peeled off from the wafer. This film was cut into a strip shape having a width of 1.5 cm and a length of 3 cm, and measurement was performed using a thermomechanical analyzer (EXSTAR 6000TMA/SS6000 manufactured by SII NanoTechnology Inc.). In the first stage, the temperature of the sample was raised to 150°C at a rate of temperature rise of 5°C/min to remove adsorbed water from the sample, and in the second stage, the sample was air cooled to room temperature at a rate of temperature fall of 5°C/min. In the third stage, the main measurement was performed at a rate of temperature rise of 5°C/min. As the coefficient of thermal expansion of the intended polyimide film, an average value in the temperature range of 50°C to 150°C in this measurement was determined. From the value of the coefficient of thermal expansion, the following determinations of A, B, and C were made, and A was determined to be good, B was determined to be tolerable, and C was determined to be bad.
A: The coefficient of thermal expansion is 20 ppm/K or more and less than 25 ppm/K.
B: The coefficient of linear expansion is 10 ppm/K or more and less than 20 ppm/K, or 25 ppm/K or more and 40 ppm/K or less.
C: The coefficient of linear expansion is less than 10 ppm/K and more than 40 ppm/K.

Next, a resin composition to be used for forming the (B) resin layer will be described. All the resin compositions obtained were each filtered through a 1 µm polytetrafluoroethylene filter (manufactured by Sumitomo Electric Industries, Ltd.) before evaluation.

Hereinafter, abbreviations of compounds used in the synthesis examples and the examples will be described.
SiDA: 1,3-bis(3-aminopropyl)tetramethyldisiloxane
BAHF: 2,2-bis(3-amino-4-hydroxyphenyl)hexafluoropropane
PDA: p-phenylenediamine
4,4'-ODA: 4,4'-diaminodiphenyl ether
ODPA: 3,3',4,4'-diphenyl ether tetracarboxylic acid dianhydride
PMDA: pyromellitic dianhydride
BPDA: 3,3',4,4'-biphenyltetracarboxylic acid dianhydride
DFA: dimethylformamide dimethyl acetal
HA: 2,2-bis[3-(3-aminobenzamido)-4-hydroxyphenyl]hexafluoropropane
NA: 5-norbornene-2,3-dicarboxylic anhydride
MAP: m-aminophenol
RT-1000: diamine containing structure of formula (1) (trade name, manufactured by HUNTSMAN Corporation)
KF-8010: diamine containing structure of formula (2) (trade name, manufactured by Shin-Etsu Chemical Co., Ltd.)
Dicarboxylic acid derivative A: 1,1'-(4,4'-oxybenzoyl)diimidazole
Dicarboxylic acid derivative B: 1,12-bis(1-imidazole)-1,12-dodecanedione
Methyl silicate 51: silicate oligomer (trade name, manufactured by Colcoat Co,. Ltd.)
TBAA: tetrabutylammonium acetate
CYCLOTENE 4022-35: TMB solution containing siloxane-modified benzocyclobutene (trade name, manufactured by The Dow Chemical Company), which has a group having a siloxane linkage, wherein the group having a siloxane linkage is a group represented by formula (2).
YDCN-700-10: cresol novolac type polyfunctional epoxy resin (trade name, manufactured by NIPPON STEEL Chemical & Material Co., Ltd.), has an alkylene oxide group, wherein the alkylene oxide group is a group represented by formula (1).
NMP: N-methyl-2-pyrrolidone
GBL: γ-butyrolactone
CHN: cyclohexanone
PGMEA: propylene glycol methyl ether acetate
TMB: 1,3,5-trimethylbenzene
MOM: 4-[1,1-bis[4-hydroxy-3,5-bis(methoxymethyl)phenyl]ethyl]-2,6-bis(methoxymethyl)phenol (crosslinking agent)
DCP: dicumyl peroxide
PAG-102: photoacid generator (trade name, manufactured by BASF)
VG-3101: monomer-type triphenylmethane-type epoxy resin (which is a trade name, manufactured by Printec Corporation)
TP5-280M: 5-naphthoquinonediazidesulfonic acid ester compound of α,α,α-tris(4-hydroxyphenyl)-1-ethyl-4-isopropylbenzene (photoacid generator) (trade name, manufactured by Toyo Gosei Co., Ltd.)
IRGANOX245: ethylene bis(oxyethylene) bis-(3-(5-tert-butyl-4-hydroxy-m-tolyl)propionate) (antioxidant) (trade name: manufactured by BASF)
LN: lithium niobate (used as substrate body, manufactured by Mitsui Mining & Smelting Co., Ltd.)

### [Synthesis Example 1] Synthesis of Polyester (P-1)

148 g of 1,1-bis(4-(2,3-epoxypropyloxy)phenyl)-3-phenylindane, 47 g of acrylic acid, 1 g of TBAA, 2.0 g of tert-butylcatechol and 244 g of PGMEA were charged, and the resulting mixture was stirred at 120°C for 5 hours. After the mixture was cooled to room temperature, 30 g of biphenyltetracarboxylic dianhydride and 1 g of TBAA were added, and the resulting mixture was stirred at 110°C for 3 hours. After the mixture was cooled to room temperature, 15 g of tetrahydrophthalic anhydride was added, and the resulting mixture was stirred at 120°C for 5 hours. After completion of the reaction, 500 g of PGMEA was added, the reaction solution was separated by extraction with a 1 N formic acid aqueous solution in order to remove an addition catalyst, and the separated reaction solution was dried with magnesium sulfate and condensed by a rotary evaporator such that the solid concentration was 40 wt%, affording a solution of polyester resin (P-1) in PGMEA.

### [Synthesis Example 2] Synthesis of Polysiloxane (P-2)

Under a dry nitrogen stream, 54.48 g (0.40 mol) of methyltrimethoxysilane, 109.07 g (0.55 mol) of phenyltrimethoxysilane, 5.88 g (corresponding to 0.05 moles of Si atom) of Methyl Silicate 51, and 155.04 g of PGMEA were charged in a 500 ml three-necked flask, and an aqueous phosphoric acid solution prepared by dissolving 0.515 g (0.30 parts by mass with based on the charged monomers) of phosphoric acid in 54.45 g of water was added thereto over 10 minutes with stirring at room temperature. Thereafter, the flask was immersed in an oil bath at 40°C and stirred for 60 minutes, and then the temperature of the oil bath was raised to 115°C over 30 minutes. After 1 hour from the start of the temperature increase, the internal temperature of the solution reached 100°C, and then the solution was heated and stirred for 2 hours (the internal temperature was 100°C), affording polysiloxane (P-2). The polysiloxane (P-2) has a group having a siloxane linkage, wherein the group having a siloxane linkage is a group represented by the formula (2). After stirring, PGMEA was added such that the solid concentration was 40 wt%.

### [Synthesis Example 3] Synthesis of Acrylic Resin (P-3)

In a 500 ml flask, 3 g of 2,2'-azobis(isobutyronitrile) and 50 g of PGMEA were charged. Thereafter, 23.0 g of methacrylic acid, 31.5 g of benzyl methacrylate, and 32.8 g of tricyclo[5.2.1.02,6]decan-8-yl methacrylate were charged thereinto, and the resulting mixture was stirred for a while at room temperature. The inside of the flask was thoroughly purged with nitrogen by bubbling, and the contents were heated and stirred at 70°C for 5 hours. Then, 12.7 g of glycidyl methacrylate, 1 g of dimethylbenzylamine, 0.2 g of p-methoxyphenol, and 100 g of PGMEA were added to the resulting solution, and the resulting mixture was heated and stirred at 90°C for 4 hours, affording acrylic resin (P-3). After stirring, PGMEA was added such that the solid concentration was 40 wt%.

### [Synthesis Example 4] Synthesis of Polyimide (P-4)

Under a dry nitrogen stream, 32.96 g (0.090 mol) of BAHF, 2.18 g (0.020 mol) of MAP, and 160 g of NMP were weighed and dissolved in a three-necked flask. To this was added a solution in which 31.02 g (0.10 mol; 100 mol% relative to the structural unit derived from all of carboxylic acids and derivatives thereof) of ODPA was dissolved in 100 g of NMP. The resultant mixture was stirred at 20°C for 1 hour, and then further stirred at 50°C for 4 hours. Thereafter, 15 g of xylene was added to the solution, and the resultant solution was stirred at 150°C for 5 hours while azeotropically distilling water together with xylene. After the completion of the reaction, the reaction solution was introduced into 3 L of water, and the solid precipitate having deposited was collected by filtration. The obtained solid material was washed with water three times and was then dried in a vacuum dryer at 80°C for 24 hours, affording a polyimide (P-4).

### [Synthesis Example 5] Synthesis of Polyimide (P-5)

Under a dry nitrogen stream, 29.30 g (0.080 mol) of BAHF, 10.00 g of RT-1000, 2.18 g (0.020 mol) of MAP, and 190 g of NMP were weighed and dissolved in a three-necked flask. To this was added a solution in which 31.02 g (0.10 mol; 100 mol% relative to the structural unit derived from all of carboxylic acids and derivatives thereof) of ODPA was dissolved in 100 g of NMP. The resultant mixture was stirred at 20°C for 1 hour, and then further stirred at 50°C for 4 hours. Thereafter, 15 g of xylene was added to the solution, and the resultant solution was stirred at 150°C for 5 hours while azeotropically distilling water together with xylene. After the completion of the reaction, the reaction solution was introduced into 3 L of water, and the solid precipitate having deposited was collected by filtration. The obtained solid material was washed with water three times and was then dried in a vacuum dryer at 80°C for 24 hours, affording a polyimide (P-5).

### [Synthesis Example 6] Synthesis of Polyimide (P-6)

Under a dry nitrogen stream, 29.30 g (0.080 mol) of BAHF, 8.6 g of KF-8010, 2.18 g (0.020 mol) of MAP, and 100 g of CHN were weighed and dissolved in a three-necked flask. To this was added 31.02 g (0.10 mol; 100 mol% relative to the structural unit derived from all of carboxylic acids and derivatives thereof) of ODPA together with 50 g of CHN. The resultant mixture was stirred at 20°C for 1 hour, and then further stirred at 50°C for 4 hours. Thereafter, the mixture was stirred at 150°C for 5 hours while azeotropically boiling water together with cyclohexanone, thereby affording polyimide (P-6).

### [Synthesis Example 7] Synthesis of Polyimide Precursor (P-7)

Under a dry nitrogen stream, 51.4 g (0.085 mol) of HA, 1.24 g (0.005 mol) of SiDA, and 2.18 g (0.020 mol) of MAP as an end-capping agent were dissolved in 200 g of NMP. To the obtained solution, 31.0 g (0.10 mol) of ODPA was added, and the resulting mixture was stirred at 40°C for 2 hours. Thereafter, a solution prepared by diluting 7.14 g (0.06 mol) of DFA with 5 g of NMP was added dropwise over 10 minutes. After completion of the dropwise addition, stirring was continuously conducted at 40°C for 2 hours. After the completion of the stirring, the solution was put into 2 L of water, and the polymer solid precipitate was collected by filtration. Following further washing three times with 2 L of water, the collected polymer solid was dried in a vacuum dryer at 50°C for 72 hours, affording polyimide precursor (P-7).

### [Synthesis Example 8] Synthesis of Polybenzoxazole Precursor (P-8)

Under a dry nitrogen stream, 36.63 g (0.100 mol) of BAHF was dissolved in 200 g of NMP. To this solution, 28.67 g (0.080 mol) of the dicarboxylic acid derivative A was added together with 20 g of NMP, and the resulting mixture was made to react at 85°C for 3 hours. Subsequently, 6.57 g (0.040 mol) of NA was added together with 10 g of NMP, and the resulting mixture was made to react at 85°C for 30 minutes. After the completion of the reaction, the mixture was cooled to room temperature, 48.02 g (0.80 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor (P-8).

### [Synthesis Example 9] Synthesis of Polybenzoxazole Precursor/Polyamide Copolymer (P-9)

Under a dry nitrogen stream, 32.96 g (0.090 mol) of BAHF and 10.00 g (0.010 mol) of RT-1000 were dissolved in 200 g of NMP. To this solution, 32.25 g (0.090 mol) of the dicarboxylic acid derivative A was added together with 20 g of NMP, and the resulting mixture was made to react at 85°C for 3 hours. Subsequently, 3.28 g (0.020 mol) of NA was added together with 10 g of NMP, and the resulting mixture was made to react at 85°C for 30 minutes. After the completion of the reaction, the mixture was cooled to room temperature, 54.02 g (0.90 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water 3 times, and then dried in a vacuum dryer at 50°C for 3 days, affording a powder of polybenzoxazole precursor/polyamide copolymer (P-9).

### [Synthesis Example 10] Synthesis of Polybenzoxazole Precursor/Polyimide precursor Copolymer (P-10)

Under a dry nitrogen stream, 32.96 g (0.090 mol) of BAHF and 10.00 g (0.010 mol) of RT-1000 were dissolved in 200 g of NMP. To this solution, 30.46 g (0.085 mol) of the dicarboxylic acid derivative A was added together with 20 g of NMP, and the resulting mixture was made to react at 85°C for 3 hours. Subsequently, 1.24 g (0.005 mol) of SiDA, 1.55 g (0.005 mol) of ODPA, and 4.92 g (0.030 mol) of NA were added together with 20 g of NMP, and the mixture was made to react at 85°C for 30 minutes. After the completion of the reaction, the mixture was cooled to room temperature, 51.02 g (0.85 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor (P-10).

### [Synthesis Example 11] Synthesis of Polybenzoxazole Precursor/Polyimide precursor Copolymer (P-11)

Under a dry nitrogen stream, 32.96 g (0.090 mol) of BAHF and 10.00 g (0.010 mol) of RT-1000 were dissolved in 200 g of NMP. To this solution, 16.13 g (0.045 mol) of the dicarboxylic acid derivative A and 13.22 g (0.040 mol) of the dicarboxylic acid derivative B were added together with 20 g of NMP, and the resulting mixture was made to react at 85°C for 3 hours. Subsequently, 1.24 g (0.005 mol) of SiDA, 1.55 g (0.005 mol) of ODPA, and 4.92 g (0.030 mol) of NA were added together with 20 g of NMP, and the mixture was made to react at 85°C for 30 minutes. After the completion of the reaction, the mixture was cooled to room temperature, 51.02 g (0.85 mol) of acetic acid was added together with 90 g of NMP, and the resulting mixture was stirred at room temperature for 1 hour. After the completion of the stirring, the solution was poured into 3 L of water, affording a white precipitate. The precipitate was collected by filtration, washed with water three times, and then dried in a vacuum dryer at 50°C for 3 days, affording a powder of polybenzoxazole precursor (P-10).

### [Synthesis Example 12] Polyimide Precursor (P-12)

Under a dry nitrogen stream, 19.2 g (0.096 mol) of 4,4'-ODA and 0.99 g (0.004 mol) of SiDA were dissolved in 200 g of NMP. To this solution, 16.8 g (0.077 mol) of PMDA and 5.9 g (0.020 mol) of BPDA were added, and the resulting mixture was stirred at 60°C for 5 hours, affording polyimide precursor solution (P-12). After stirring, NMP was added such that the solid concentration was 16 wt%.

### [Synthesis Example 13] Polyimide Precursor (P-13)

Under a dry nitrogen stream, 10.4 g (0.096 mol) of PDA and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-13). After stirring, NMP was added such that the solid concentration was 16 wt%.

### [Synthesis Example 14] Polyimide Precursor (P-14)

Under a dry nitrogen stream, 7.8 g (0.072 mol) of PDA, 4.8 g (0.024 mol) of 4,4'-ODA, and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-14). After stirring, NMP was added such that the solid concentration was 16 wt%.

### [Synthesis Example 15] Polyimide Precursor (P-15)

Under a dry nitrogen stream, 20.4 g (0.096 mol) of 2,2'-dimethyl-4,4'-diaminobiphenyl and 0.99 g (0.004 mol) of SiDA were dissolved in 200 g of NMP. To this solution, 28.5 g (0.097 mol) of BPDA was added, and the resulting mixture was stirred at 60°C for 5 hours, affording polyimide precursor solution (P-15). After stirring, NMP was added such that the solid concentration was 16 wt%.

### [Synthesis Example 16] Polyimide Precursor (P-16)

Under a dry nitrogen stream, 10.8 g (0.1 mol) of PDA was dissolved in 200 g of NMP. To this solution, 10.7 g (0.049 mol) of PMDA and 26.5 g (0.049 mol) of BPDA were added, and the resulting mixture was stirred at 60°C for 5 hours, affording polyimide precursor solution (P-16). After stirring, NMP was added such that the solid concentration was 16 wt%.

### [Comparative Synthesis Example 1] Synthesis of Polystyrene (HP-1)

A 500 ml flask equipped with a reflux tube was charged with 200 mL of tetrahydrofuran, 2 g of 2,2'-azobis(isobutyronitrile), and 40 g of styrene. Thereafter, the mixture was stirred at room temperature for a while, the inside of the flask was sufficiently purged with nitrogen by bubbling, and then the mixture was heated and stirred at 80°C for 5 hours while refluxing the solvent. After the completion of the stirring, the solution was poured into 2 L of methanol, affording a white precipitate. This precipitate was collected by filtration, washed twice with methanol, and then dried overnight by vacuum drying at room temperature, affording a powder of polystyrene (HP-1).

### [Adjustment Examples 1 to 27] [Comparative Adjustment Example 1]

A resin obtained in Synthesis Example or a ready-made resin was mixed with a solvent and an additive such that the weight ratio and the solid concentration shown in Table 1 were attained, affording each resin composition.

**[Table 1-1]**

| | Resin composi tion | Resin | Specific functional group in resin | Specific structure in resin | parts by weight | Additive 1 | parts by weight | Additive 2 | parts by weight | Additive 3 | parts by weight | Solvent | Solid concent ration |
|---|---|---|---|---|---|---|---|---|---|---|---|---|---|
| Adjustment Example 1 | V-1 | P-1 | Carbonyl group | | 100 | DCP | 3 | | | | | PGMEA | 30 wt% |
| Adjustment Example 2 | V-2 | P-2 | Siloxane linkage group | Formula (2) | 100 | PAG-102 | 3 | | | | | PGMEA | 30 wt% |
| Adjustment Example 3 | V-3 | P-3 | Carbonyl group | | 100 | DCP | 3 | | | | | PGMEA | 30 wt% |
| Adjustment Example 4 | V-4 | P-4 | Carbonyl group, nitrogen-containing heterocyclic ring, hydroxy group | | 100 | | | | | | | GBL | 30 wt% |
| Adjustment Example 5 | V-5 | P-5 | Carbonyl group, nitrogen-containing heterocyclic ring, alkylene oxide group, hydroxy group | Formula (1) | 100 | | | | | | | GBL | 30 wt% |
| Adjustment Example 6 | V-6 | P-6 | Carbonyl group, nitrogen-containing heterocyclic ring, siloxane linkage group, hydroxy group | Formula (2) | 100 | | | | | | | CHN | 30 wt% |
| Adjustment Example 7 | V-7 | P-7 | Carbonyl group, nitrogen-containing heterocyclic ring, siloxane linkage group, hydroxy group | Formula (2) | 100 | | | | | | | GBL | 30 wt% |
| Adjustment Example 8 | V-8 | P-8 | Carbonyl group, nitrogen-containing heterocyclic ring, hydroxy group | | 100 | | | | | | | GBL | 30 wt% |
| Adjustment Example 9 | V-9 | P-9 | Carbonyl group, nitrogen-containing heterocyclic ring, alkylene oxide group, hydroxy group | Formula (1) | 100 | | | | | | | GBL | 30 wt% |
| Adjustment Example 10 | V-10 | P-10 | Carbonyl group, nitrogen-containing heterocyclic ring, alkylene oxide group, hydroxy aroup | Formula (1) | 100 | | | | | | | GBL | 30 wt% |

**[Table 1-2]**

| | Resin composi tion | Resin | Specific functional group in resin | Specific structure in resin | parts by weight | Additive 1 | parts by weight | Additive 2 | parts by weight | Additive 3 | parts by weight | Solvent | Solid concent ration |
|---|---|---|---|---|---|---|---|---|---|---|---|---|---|
| Adjustment Example 11 | V-11 | P-11 | Carbonyl group, nitrogen-containing heterocyclic ring, alkylene oxide group, hydroxy group | Formula (1) | 100 | | | | | | | GBL | 30 wt% |
| Adjustment Example 12 | V-12 | YDCN -700-10 | Alkylene oxide group | Formula (1) | 100 | VG-3101L | 10 | PAG-102 | 3 | | | PGMEA | 30 wt% |
| Adjustment Example 13 | V-13 | P-7 | Carbonyl group, nitrogen-containing heterocyclic ring, siloxane linkage group, hydroxy group | Formula (2) | 100 | IRGANOX 245 | 3 | | | | | GBL | 30 wt% |
| Adjustment Example 14 | V-14 | P-9 | Carbonyl group, nitrogen-containing heterocyclic ring, alkylene oxide group, hydroxy group | Formula (1) | 100 | IRGANOX 245 | 3 | | | | | GBL | 30 wt% |
| Adjustment Example 15 | V-15 | P-11 | Carbonyl group, nitrogen-containing heterocyclic ring, alkylene oxide group, hydroxy group | Formula (1) | 100 | IRGANOX 245 | 3 | | | | | GBL | 30 wt% |
| Adjustment Example 16 | V-16 | P-7 | Carbonyl group, nitrogen-containing heterocyclic ring, siloxane linkage group, hydroxy group | Formula (2) | 100 | IRGANOX 245 | 3 | MOM | 10 | | | GBL | 30 wt% |
| Adjustment Example 17 | V-17 | P-9 | Carbonyl group, nitrogen-containing heterocyclic ring, alkylene oxide group, hydroxy group | Formula (1) | 100 | IRGANOX 245 | 3 | MOM | 10 | | | GBL | 30 wt% |
| Adjustment Example 18 | V-18 | P-11 | Carbonyl group, nitrogen-containing heterocyclic ring, alkylene oxide group, hydroxy group | Formula (1) | 100 | IRGANOX 245 | 3 | MOM | 10 | | | GBL | 30 wt% |
| Adjustment Example 19 | V-19 | P-7 | Carbonyl group, nitrogen-containing heterocyclic ring, siloxane linkage group, hydroxy group | Formula (2) | 100 | IRGANOX 245 | 3 | MOM | 10 | TP5-280M | 15 | GBL | 30 wt% |

**[Table 1-3]**

| | Resin composi tion | Resin | Specific functional group in resin | Specific structure in resin | parts by weight | Additive 1 | parts by weight | Additive 2 | parts by weight | Additive 3 | parts by weight | Solvent | Solid concent ration |
|---|---|---|---|---|---|---|---|---|---|---|---|---|---|
| Adjustment Example 20 | V-20 | P-9 | Carbonyl group, nitrogen-containing heterocyclic ring, alkylene oxide group, hydroxy group | Formula (1) | 100 | IRGANOX 245 | 3 | MOM | 10 | TP5-280M | 15 | GBL | 30 wt% |
| Adjustment Example 21 | V-21 | P-11 | Carbonyl group, nitrogen-containing heterocyclic ring, alkylene oxide group, hydroxy group | Formula (1) | 100 | IRGANOX 245 | 3 | MOM | 10 | TP5-280M | 15 | GBL | 30 wt% |
| Adjustment Example 22 | V-22 | CYCLOTENE 4022-35 | Siloxane linkage group | Formula (2) | | | | | | | | TMB | 30 wt% |
| Adjustment Example 23 | V-23 | P-12 | Carbonyl group, nitrogen-containing heterocyclic ring, siloxane linkage group | Formula (2), Formula (9) | 100 | IRGANOX 245 | 3 | | | | | NMP | 16 wt% |
| Adjustment Example 24 | V-24 | P-13 | Carbonyl group, nitrogen-containing heterocyclic ring, siloxane linkage group | Formula (2), Formula (9) | 100 | IRGANOX 245 | 3 | | | | | NMP | 16 wt% |
| Adjustment Example 25 | V-25 | P-14 | Carbonyl group, nitrogen-containing heterocyclic ring, siloxane linkage group | Formula (2), Formula (9) | 100 | IRGANOX 245 | 3 | | | | | NMP | 16 wt% |
| Adjustment Example 26 | V-26 | P-15 | Carbonyl group, nitrogen-containing heterocyclic ring, siloxane linkage group | Formula (2), Formula (9) | 100 | IRGANOX 245 | 3 | | | | | NMP | 16 wt% |
| Adjustment Example 27 | V-27 | P-16 | Carbonyl group, nitrogen-containing heterocyclic ring | Formula (9) | 100 | IRGANOX 245 | 3 | | | | | NMP | 16 wt% |
| Comparative Adjustment Example 1 | HV-1 | HP-1 | - | - | 100 | | | | | | | PGMEA | 30 wt% |

### [Examples 1 to 48, 51 to 55, 58 to 62] [Comparative Examples 1 and 3]

Using the resin compositions prepared in Adjustment Examples and Comparative Adjustment Examples and commercially available resin compositions, laminates were prepared by the above-described laminate preparation methods (1) to (5), and the evaluation of the laminates was performed by the physical property measurement methods (6) to (8) of a resin layer and a resin composition. These Examples and Comparative Examples are shown in Tables 2 and 3.

### [Examples 49 to 50, 56 and 57] [Comparative Examples 2 and 4]

Laminates were prepared in the same manner as in the laminate preparation methods (1) to (5) described above except that tetraethoxysilane was used and a SiO₂ film was formed by a chemical vapor deposition method instead of (1-2) Formation of Resin Layer, and the evaluation of the laminates was performed by the physical property measurement methods (5) to (8) of a resin layer and a resin composition. These Examples and Comparative Examples are shown in Tables 2 and 3.

**[Table 2-1]**

| | Substrate configuration | | | | | | | | | Evaluation results of laminate | | | |
|---|---|---|---|---|---|---|---|---|---|---|---|---|---|
| | First substrate | | | | Second substrate | | | | Laminate configur ation | Adhesive force (MPa) | | Reliability test | |
| | Substrate body | (A-1) Metal electrode | (B-1) Resin layer | Elastic modulus (GPa) of (B-1) resin layer | Substrate body | (A-2) Metal electrode | (B-2) Resin layer | Elastic modulus (GPa) of (B-2) resin layer | | After annealing | After PCT | HTS | TC |
| Example 1 | Si | Cu | V-1 | 3.0 | Si | Cu | V-1 | 3.0 | W2W | 15 | 12 | 2 | 3 |
| Example 2 | Si | Cu | V-2 | 4.2 | Si | Cu | V-2 | 4.2 | W2W | 12 | 7 | 2 | 2 |
| Example 3 | Si | Cu | V-3 | 4.3 | Si | Cu | V-3 | 4.3 | W2W | 12 | 7 | 2 | 2 |
| Example 4 | Si | Cu | V-4 | 4.1 | Si | Cu | V-4 | 4.1 | W2W | 15 | 12 | 3 | 3 |
| Example 5 | Si | Cu | V-5 | 2.9 | Si | Cu | V-5 | 2.9 | W2W | 25 | 22 | 3 | 4 |
| Example 6 | Si | Cu | V-6 | 1.0 | Si | Cu | V-6 | 1.0 | W2W | 25 | 22 | 2 | 4 |
| Example 7 | Si | Cu | V-7 | 4.4 | Si | Cu | V-7 | 4.4 | W2W | 15 | 12 | 3 | 3 |
| Example 8 | Si | Cu | V-8 | 3.7 | Si | Cu | V-8 | 3.7 | W2W | 15 | 12 | 3 | 3 |
| Example 9 | Si | Cu | V-9 | 3.4 | Si | Cu | V-9 | 3.4 | W2W | 25 | 21 | 3 | 4 |
| Example 10 | Si | Cu | V-10 | 3.3 | Si | Cu | V-10 | 3.3 | W2W | 25 | 21 | 3 | 4 |
| Example 11 | Si | Cu | V-11 | 3.2 | Si | Cu | V-11 | 3.2 | W2W | 30 | 25 | 3 | 4 |
| Example 12 | Si | Cu | V-12 | 3.5 | Si | Cu | V-12 | 3.5 | W2W | 15 | 10 | 3 | 3 |
| Example 13 | Si | Cu | V-13 | 4.4 | Si | Cu | V-13 | 4.4 | W2W | 15 | 13 | 4 | 4 |
| Example 14 | Si | Cu | V-14 | 3.4 | Si | Cu | V-14 | 3.4 | W2W | 25 | 23 | 4 | 4 |
| Example 15 | Si | Cu | V-15 | 3.2 | Si | Cu | V-15 | 3.2 | W2W | 30 | 27 | 4 | 4 |
| Example 16 | Si | Cu | V-16 | 5.4 | Si | Cu | V-16 | 5.4 | W2W | 18 | 16 | 4 | 4 |
| Example 17 | Si | Cu | V-17 | 4.2 | Si | Cu | V-17 | 4.2 | W2W | 28 | 26 | 4 | 4 |

| | | | | | | | | | | | | | |
|---|---|---|---|---|---|---|---|---|---|---|---|---|---|
| * (C) SiO₂ instead of resin layer | | | | | | | | | | | | | |

**[Table 2-2]**

| | Substrate configuration | | | | | | | | | Evaluation results of laminate | | | |
|---|---|---|---|---|---|---|---|---|---|---|---|---|---|
| | First substrate | | | | Second substrate | | | | Laminate configur ation | Adhesive force (MPa) | | Reliability test | |
| | Substrate body | (A-1) Metal electrode | (B-1) Resin layer | Elastic modulus (GPa) of (B-1) resin layer | Substrate body | (A-2) Metal electrode | (B-2) Resin layer | Elastic modulus (GPa) of (B-2) resin layer | | After annealing | After PCT | HTS | TC |
| Example 18 | Si | Cu | V-18 | 4.0 | Si | Cu | V-15 | 4.0 | W2W | 33 | 31 | 4 | 4 |
| Example 19 | Si | Cu | V-19 | 5.9 | Si | Cu | V-16 | 5.9 | W2W | 20 | 18 | 4 | 4 |
| Example 20 | Si | Cu | V-20 | 4.5 | Si | Cu | V-17 | 4.5 | W2W | 30 | 28 | 4 | 4 |
| Example 21 | Si | Cu | V-21 | 4.3 | Si | Cu | V-21 | 4.3 | W2W | 35 | 33 | 4 | 4 |
| Example 22 | Si | Cu | V-22 | 3.4 | Si | Cu | V-22 | 3.4 | W2W | 15 | 10 | 3 | 2 |
| Example 23 | Si | Cu | V-21 | 4.3 | LN | Cu | V-21 | 4.3 | W2W | 35 | 33 | 4 | 4 |
| Example 24 | LN | Cu | V-21 | 4.3 | LN | Cu | V-21 | 4.3 | W2W | 35 | 33 | 4 | 4 |
| Example 49 | Si | Cu | V-21 | 4.3 | Si | Cu | - (*) | - | W2W | 34 | 30 | 4 | 4 |
| Example 50 | Si | Cu | V-25 | 5.4 | Si | Cu | - (*) | - | W2W | 22 | 19 | 4 | 4 |
| Example 51 | Si | Cu | V-23 | 5.1 | Si | Cu | V-23 | 5.1 | W2W | 24 | 23 | 4 | 4 |
| Example 52 | Si | Cu | V-24 | 6.9 | Si | Cu | V-24 | 6.9 | W2W | 23 | 22 | 4 | 4 |
| Example 53 | Si | Cu | V-25 | 5.4 | Si | Cu | V-25 | 5.4 | W2W | 25 | 23 | 4 | 4 |
| Example 54 | Si | Cu | V-26 | 6.1 | Si | Cu | V-26 | 6.1 | W2W | 24 | 22 | 4 | 4 |
| Example 55 | Si | Cu | V-27 | 5.8 | Si | Cu | V-27 | 5.8 | W2W | 12 | 7 | 2 | 4 |
| Comparative Example 1 | Si | Cu | HV-1 | 1.5 | Si | Cu | HV-1 | 1.5 | W2W | 8 | 4 | 1 | 2 |
| Comparative Example 2 | Si | Cu | - (*) | - | Si | Cu | - (*) | - | W2W | 8 | 4 | 4 | 1 |

| | | | | | | | | | | | | | |
|---|---|---|---|---|---|---|---|---|---|---|---|---|---|
| * (C) SiO₂ instead of resin layer | | | | | | | | | | | | | |

**[Table 3-1]**

| | Substrate configuration | | | | | | | | | Evaluation results of laminate | | | |
|---|---|---|---|---|---|---|---|---|---|---|---|---|---|
| | First substrate | | | | Second substrate | | | | Laminate configuration | Adhesive force (MPa) | | Reliability test | |
| | Substrate body | (A-1) Metal electrode | (B-1) Resin layer | Elastic modulus (GPa) of (B-1) resin layer | Substrate body | (A-2) Metal electrode | (B-2) Resin layer | Elastic modulus (GPa) of (B-2) resin layer | | After annealing | After PCT | HTS | TC |
| Example 25 | Si | Cu | V-1 | 3.0 | Si | Cu | V-1 | 3.0 | C2W | 15 | 12 | 2 | 3 |
| Example 26 | Si | Cu | V-2 | 4.2 | Si | Cu | V-2 | 4.2 | C2W | 12 | 7 | 2 | 2 |
| Example 27 | Si | Cu | V-3 | 4.3 | Si | Cu | V-3 | 4.3 | C2W | 12 | 7 | 2 | 2 |
| Example 28 | Si | Cu | V-4 | 4.1 | Si | Cu | V-4 | 4.1 | C2W | 15 | 12 | 3 | 3 |
| Example 29 | Si | Cu | V-5 | 2.9 | Si | Cu | V-5 | 2.9 | C2W | 25 | 22 | 3 | 4 |
| Example 30 | Si | Cu | V-6 | 1.0 | Si | Cu | V-6 | 1.0 | C2W | 25 | 22 | 2 | 4 |
| Example 31 | Si | Cu | V-7 | 4.4 | Si | Cu | V-7 | 4.4 | C2W | 15 | 12 | 3 | 3 |
| Example 32 | Si | Cu | V-8 | 3.7 | Si | Cu | V-8 | 3.7 | C2W | 15 | 12 | 3 | 3 |
| Example 33 | Si | Cu | V-9 | 3.4 | Si | Cu | V-9 | 3.4 | C2W | 25 | 21 | 3 | 4 |
| Example 34 | Si | Cu | V-10 | 3.3 | Si | Cu | V-10 | 3.3 | C2W | 25 | 21 | 3 | 4 |
| Example 35 | Si | Cu | V-11 | 3.2 | Si | Cu | V-11 | 3.2 | C2W | 30 | 25 | 3 | 4 |
| Example 36 | Si | Cu | V-12 | 3.5 | Si | Cu | V-12 | 3.5 | C2W | 15 | 10 | 3 | 3 |
| Example 37 | Si | Cu | V-13 | 4.4 | Si | Cu | V-13 | 4.4 | C2W | 15 | 13 | 4 | 4 |
| Example 38 | Si | Cu | V-14 | 3.4 | Si | Cu | V-14 | 3.4 | C2W | 25 | 23 | 4 | 4 |
| Example 39 | Si | Cu | V-15 | 3.2 | Si | Cu | V-15 | 3.2 | C2W | 30 | 27 | 4 | 4 |
| Example 40 | Si | Cu | V-16 | 5.4 | Si | Cu | V-16 | 5.4 | C2W | 18 | 16 | 4 | 4 |
| Example 41 | Si | Cu | V-17 | 4.2 | Si | Cu | V-17 | 4.2 | C2W | 28 | 26 | 4 | 4 |

| | | | | | | | | | | | | | |
|---|---|---|---|---|---|---|---|---|---|---|---|---|---|
| * (C) SiO₂ instead of resin layer | | | | | | | | | | | | | |

**[Table 3-2]**

| | Substrate configuration | | | | | | | | | Evaluation results of laminate | | | |
|---|---|---|---|---|---|---|---|---|---|---|---|---|---|
| | First substrate | | | | Second substrate | | | | Laminate configuration | Adhesive force (MPa) | | Reliability test | |
| | Substrate body | (A-1) Metal electrode | (B-1) Resin layer | Elastic modulus (GPa) of (B-1) resin layer | Substrate body | (A-2) Metal electrode | (B-2) Resin layer | Elastic modulus (GPa) of (B-2) resin layer | | After annealing | After PCT | HTS | TC |
| Example 42 | Si | Cu | V-18 | 4.0 | Si | Cu | V-15 | 4.0 | C2W | 33 | 31 | 4 | 4 |
| Example 43 | Si | Cu | V-19 | 5.9 | Si | Cu | V-16 | 5.9 | C2W | 20 | 18 | 4 | 4 |
| Example 44 | Si | Cu | V-20 | 4.5 | Si | Cu | V-17 | 4.5 | C2W | 30 | 28 | 4 | 4 |
| Example 45 | Si | Cu | V-21 | 4.3 | Si | Cu | V-21 | 4.3 | C2W | 35 | 33 | 4 | 4 |
| Example 46 | Si | Cu | V-22 | 3.4 | Si | Cu | V-22 | 3.4 | C2W | 15 | 10 | 3 | 2 |
| Example 47 | Si | Cu | V-21 | 4.3 | LN | Cu | V-21 | 4.3 | C2W | 35 | 33 | 4 | 4 |
| Example 48 | LN | Cu | V-21 | 4.3 | LN | Cu | V-21 | 4.3 | C2W | 35 | 33 | 4 | 4 |
| Example 56 | Si | Cu | V-21 | 4.3 | Si | Cu | - (*) | - | C2W | 34 | 31 | 4 | 4 |
| Example 57 | Si | Cu | V-25 | 5.4 | Si | Cu | - (*) | - | *C2W* | 22 | 20 | 4 | 4 |
| Example 58 | Si | Cu | V-23 | 5.1 | Si | Cu | V-23 | 5.1 | C2W | 24 | 23 | 4 | 4 |
| Example 59 | Si | Cu | V-24 | 6.9 | Si | Cu | V-24 | 6.9 | C2W | 25 | 24 | 4 | 4 |
| Example 60 | Si | Cu | V-25 | 5.4 | Si | Cu | V-25 | 5.4 | C2W | 27 | 25 | 4 | 4 |
| Example 61 | Si | Cu | V-26 | 6.1 | Si | Cu | V-26 | 6.1 | C2W | 27 | 24 | 4 | 4 |
| Example 62 | Si | Cu | V-27 | 5.8 | Si | Cu | V-27 | 5.8 | C2W | 12 | 7 | 2 | 4 |
| Comparative Example 3 | Si | Cu | HV-1 | 1.5 | Si | Cu | HV-1 | 1.5 | C2W | 8 | 4 | 1 | 2 |
| Comparative Example 4 | Si | Cu | - (*) | - | Si | Cu | - (*) | - | C2W | 5 | 2 | 4 | 1 |

| | | | | | | | | | | | | | |
|---|---|---|---|---|---|---|---|---|---|---|---|---|---|
| * (C) SiO₂ instead of resin layer | | | | | | | | | | | | | |

### [Preparation Examples 23 to 25, Comparative Preparation Example 1]

The evaluation was performed by the method for measuring physical properties of resin composition (9). The preparation examples and the comparative preparation examples are shown in Table 4.

**[Table 4]**

| | Resin composition | Resin | CTE ppm/K | |
|---|---|---|---|---|
| | | | | Determination |
| Adjustment Example 23 | V-23 | P-12 | 34 | B |
| Adjustment Example 24 | V-24 | P-13 | 20 | A |
| Adjustment Example 25 | V-25 | P-14 | 23 | A |
| Adjustment Example 26 | V-26 | P-15 | 21 | A |
| Adjustment Example 27 | V-27 | P-16 | 4 | C |
| Comparative Adjustment Example 1 | HV-1 | HP-1 | 60 | C |

### DESCRIPTION OF REFERENCE SIGNS

1: Substrate body (silicon wafer or the like)
2: (A-1) Metal electrode (Cu or the like)
3: (B-1) Resin layer
4: (B-2) Resin layer or (C) inorganic insulating layer
5: (A-2) Metal electrode (Cu or the like)
6: Substrate body (silicon wafer or the like)
7: First substrate
8: Second substrate

## Claims

1. A laminate in which
a first substrate including an exposed (A-1) metal electrode and an exposed (B-1) resin layer provided on the same face of a substrate body, and
a second substrate including an exposed (A-2) metal electrode and an exposed (B-2) resin layer, or an exposed (A-2) metal electrode and an exposed (C) inorganic insulating layer provided on the same face of a substrate body,
are laminated together such that
the (A-2) metal electrode and at least a part of the (A-1) metal electrode and the (B-2) resin layer and at least a part of the (B-1) resin layer, or
the (A-2) metal electrode and at least a part of the (A-1) metal electrode and the (C) inorganic insulating layer and at least a part of the (B-1) resin layer are directly bonded, respectively,
wherein at least one of the (B-1) resin layer and the (B-2) resin layer contains a resin having one or more selected from the group consisting of a carbonyl group, a hydroxy group, alkylene oxide groups, groups having a siloxane linkage, and nitrogen-containing heterocyclic rings.

2. The laminate according to claim 1, wherein the second substrate includes the exposed (A-2) metal electrode and the exposed (B-2) resin layer provided on the same face of a substrate body.

3. The laminate according to claim 1 or 2, wherein the alkylene oxide group is a group represented by formula (1) : 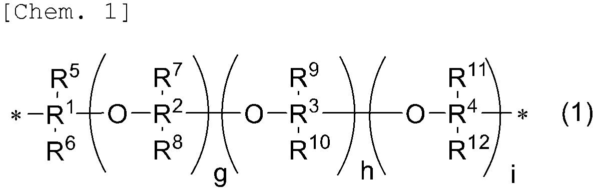 in the formula (1), R¹ to R⁴ each independently represent an alkylene group having 1 to 6 carbon atoms; R⁵ to R¹² each independently represent a hydrogen atom, a fluorine atom, or an alkyl group having 1 to 6 carbon atoms; it is noted that parenthesized structures are different from each other; g, h, and i each independently represent an integer of 0 to 35, and g + h + i > 0; and sign * represents a bonding site.

4. The laminate according to claim 1 or 2, wherein the group having a siloxane linkage is a group represented by formula (2): 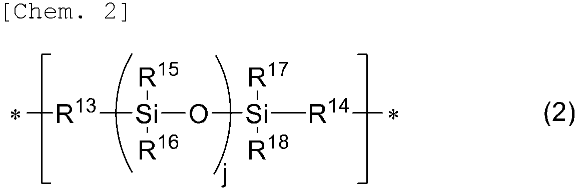 in the formula (2), j is a natural number of 1 to 50; R¹³ and R¹⁴ each independently represent an alkylene group having 1 to 30 carbon atoms, an alkenylene group having 2 to 10 carbon atoms, an alkynylene group having 2 to 10 carbon atoms, or a phenylene group having 6 to 20 carbon atoms; R¹⁵ to R¹⁸ each independently represent an alkyl group having 1 to 30 carbon atoms, a phenyl group, or a phenoxy group; and sign * represents a bonding site.

5. The laminate according to claim 3 or 4, wherein at least one of the (B-1) resin layer and the (B-2) resin layer contains one or more resins which are selected from the group consisting of polyimides, polyimide precursors, polybenzoxazoles, polybenzoxazole precursors, polyamides excluding the polyimide precursors and the polybenzoxazole precursors, and copolymers thereof and which have a group represented by the formula (1) or the formula (2).

6. The laminate according to claim 1 or 2, wherein the resin contained in at least one of the (B-1) resin layer and the (B-2) resin layer contains two or more types of structures represented by formula (9): 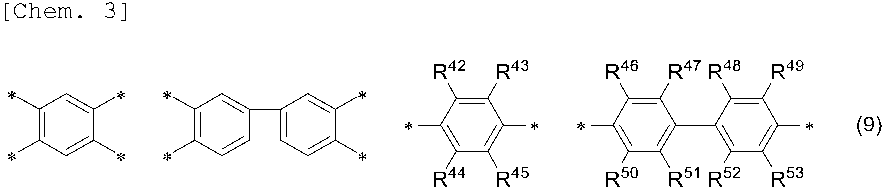 wherein sign * represents a bonding site; R⁴² to R⁵³ each independently represent a hydrogen atom, a fluorine atom, a hydroxy group, or a hydrocarbon group having 1 to 6 carbon atoms, which may be partially or fully substituted with one or more among a fluorine atom, a hydroxy group, and a carboxyl group.

7. The laminate according to claim 1 or 2, wherein a coefficient of thermal expansion of at least one of the (B-1) resin layer and the (B-2) resin layer in a temperature range of 50°C to 150°C is 10 ppm/K or more and 40 ppm/K or less.

8. The laminate according to claim 1 or 2, wherein at least one of the (B-1) resin layer and the (B-2) resin layer further contains an antioxidant.

9. The laminate according to claim 1 or 2, wherein at least one of the (B-1) resin layer and the (B-2) resin layer forms a crosslinked structure.

10. The laminate according to claim 1 or 2, wherein at least one of the (B-1) resin layer and the (B-2) resin layer has an elastic modulus of 1.5 GPa or more and 7 GPa or less.

11. The laminate according to claim 1 or 2, wherein a plurality of singulated pieces of the first substrate is directly bonded onto the same face of the second substrate.

12. The laminate according to claim 1 or 2, wherein a bonding strength between the first substrate and the second substrate as measured in a die shear test is 10 MPa or more.

13. The laminate according to claim 1 or 2, wherein at least one of the substrate bodies of the first substrate and the second substrate contains one or more selected from the group consisting of silicon, niobium lithate, tantalum lithate, gallium nitride, silicon carbide, gallium arsenide, and indium phosphide.

14. A semiconductor element comprising the laminate according to claim 1 or 2.

15. An MEMS element comprising the laminate according to claim 1 or 2.
